# EUROPEAN PATENT APPLICATION

(11) **EP 1 420 085 A2**
(43) Date of publication of application: **19.05.2004**
(21) Application number: 03024768.8
(22) Date of filing: 29.10.2003
(51) Int. Cl.: C25D 9/04, C23C 28/00, H01L 31/18

(54) **Zinc oxide film, photovoltaic device, and zinc oxide film formation process**

(30) Priority: 30.10.2002 JP 2002315996; 26.03.2003 JP 2003084778; 26.03.2003 JP 2003085477; 09.05.2003 JP 2003131732
(71) Applicant: CANON KABUSHIKI KAISHA, Ohta-ku, Tokyo (JP)
(72) Inventor: Kondo, Takaharu, Ohta-ku, Tokyo (JP); Toyama, Noboru, Ohta-ku, Tokyo (JP); Hayashi, Ryo, Ohta-ku, Tokyo (JP); Sonoda, Yuichi, Ohta-ku, Tokyo (JP); Nishimoto, Tomonori, Ohta-ku, Tokyo (JP); Yamada, Satoru, Ohta-ku, Tokyo (JP); Higashikawa, Makoto, Ohta-ku, Tokyo (JP); Iwata, Masumitsu, Ohta-ku, Tokyo (JP); Miyamoto, Yusuke, Ohta-ku, Tokyo (JP)
(74) Representative: Leson, Thomas Johannes Alois, Dipl.-Ing.

(57) **Abstract**

In a zinc oxide film having a plurality of texture constituents comprised of hills each having structure wherein a first surface borders on a second surface along one curved line, texture constituents in which first surfaces the hills of the texture constituents have an average angle of inclination in a size within the range of from 30 degrees or more to 60 degrees or less and second surfaces have an average angle of inclination in a size within the range of from 10 degrees or more to 35 degrees or less account for at least a half of the plurality of texture constituents. This enables improvement in characteristics and durability of zinc oxide films used as optical confinement layers in photovoltaic devices, and also enables formation thereof at a low cost.

## Description

### BACKGROUND OF THE INVENTION

### Field of the Invention

This invention relates to a zinc oxide film, a photovoltaic device making use of the same and a zinc oxide film formation process.

### Related Background Art

In photovoltaic devices formed of amorphous silicon hydride, amorphous silicon germanium hydride, amorphous silicon carbide hydride, microcrystalline silicon, polycrystalline silicon or the like, reflection layers have conventionally been used on their backs in order to improve light collection efficiency at long wavelengths. Such reflection layers may preferably be those showing effective reflection characteristics at wavelengths where absorption is small in the vicinity of band ends of semiconductor materials, i.e., at 800 to 1,200 nm. What satisfy this condition are metals such as gold, silver, copper and aluminum or alloys of any of these. It is also current to provide an uneven layer that is optically transparent at stated wavelengths, known as a optical confinement layer, and it is commonly attempted to provide an uneven transparent conductive layer between the above reflection layer (metal layer) and a semiconductor layer so that the reflected light can effectively be utilized to improve short-circuit current density Jsc. Further, this transparent conductive layer prevents characteristics from lowering because of shunt paths. Very commonly, these layers are film-formed by vacuum deposition or sputtering, showing an improvement in short-circuit current density.

For example, as reported in Optical confinement effect in a-SiGe Solar Cell on 29p-MF-22 Stainless Steel, Autumn in 1990, 51st Applied Physics Society Scientific Lectures, Lecture Collections, p.747 (hereinafter Non-patent Literature 1), and P-IA-15 a-SiC/a-Si/a-SiGe Multi-bandgap Stacked Solar Cells with Bandgap Profiling, Sannomiya et al., Technical Digest of The International PVSEC-5, kyoto, Japan, p.381, 1990 (hereinafter Non-patent Literature 2), studies are made on reflectance and textured structure in respect of reflection layers constituted of silver atoms. In these examples, the reflection layer is formed by double-layer deposition of silver at substrate temperature changed for each layer, to form effective unevenness, and this has achieved enhancement of short-circuit current in virtue of the optical confinement effect, in combination with a zinc oxide film, as so reported.

Japanese Patent No. 3273294 (hereinafter Patent Literature 1) discloses that a zinc oxide film formed using an electrolytic solution for forming zinc oxide films which is comprised of an aqueous solution containing 0.001 to 0.5 mol/l of zinc ions and 0.001 to 0.5 mol/l of nitrate ions has uniform layer thickness and composition and has superior optical transparency.

Japanese Patent Application Laid-Open No. H10-140373 (hereinafter Patent Literature 2) also discloses that a zinc oxide thin-film production process characterized by having the step of forming a first zinc oxide thin film on a substrate by sputtering and the step of forming on the first zinc oxide thin film a second zinc oxide thin film by immersing the substrate in an aqueous solution containing at least nitrate ions, zinc ions and a carbohydrate, followed by electrification across electrodes immersed in the solution can be carried out at a low cost, can keep the films from any abnormal growth, and can form zinc oxide thin films having superior substrate adherence.

Japanese Patent Application Laid-Open No. 2002-167695 (hereinafter Patent Literature 3) further discloses that, in a zinc oxide film formation process which forms a zinc oxide film on a conductive substrate by immersing the conductive substrate and an opposing electrode in an aqueous solution containing at least nitrate ions and zinc ions, followed by electrification across the conductive substrate and the opposing electrode, a zinc oxide film formed using as the aqueous solution an aqueous solution containing a polyhydric carboxylic acid, or an ester thereof, in which carboxyl groups are bonded to a plurality of carbon atoms each having an sp² hybrid orbital has a textured profile having a high optical confinement effect.

As stated above, optical confinement layers having already been disclosed are those having good photoelectric conversion characteristics.

However, in the above Non-patent Literatures 1 and 2, the zinc oxide film is formed only by vacuum deposition utilizing resistance heating or electron beams, sputtering, ion plating, CVD (chemical vapor deposition) or the like, resulting in a high cost for making target materials, a great expenditure for the refund of vacuum systems and a low utilization efficiency of materials, these of which make very high the cost of photovoltaic devices making use of these techniques. This puts up barriers against attempts to apply solar cells in an industrial scale. It has also been difficult to control the size of angles of inclination in the textured structure.

In the case of a photoelectric conversion layer formed of a thin film of, e.g., amorphous silicon hydride and microcrystalline silicon or polycrystalline silicon, there has been a problem that a photovoltaic device making use of a semiconductor surface with a sharper textured profile in order to improve the optical confinement effect may bring about a difficulty that it triggers a shunt path, making insufficient the effect of improving photoelectric conversion characteristics.

In the Patent Literature 1, a technique is disclosed which relates to the formation of a zinc oxide film having uniform layer thickness and composition and having superior optical characteristics, but refers to nothing as to the formation of any zinc oxide film having the textured structure. For example, in a photovoltaic device in which semiconductor layers are superposingly formed on a substrate having a zinc oxide film on its surface, the optical confinement effect is not sufficiently exhibited when a layer with uniform thickness is used as the zinc oxide film, making insufficient the effect of improving photoelectric conversion characteristics, in particular, increasing short-circuit current. Also, where the surface has a relatively smooth profile as a zinc oxide film, the factor of irregular reflection reduces to lower the optical confinement effect, making small the photoelectric conversion characteristics, in particular, the short-circuit current.

As to the zinc oxide thin film formed by electrodeposition from the aqueous solution containing zinc ions and nitrate ions, abnormal growth in a shape such as an acicular shape, a spherical shape or a resinous shape that may exceed the micron order tends to take place on a deposited film when the film is formed under conditions where the current density is made higher or the concentration of the aqueous solution is made higher. If this zinc oxide film is used as a part of a photovoltaic device, such abnormal growth is considered to be the cause that triggers the shunt path in the photovoltaic device. Further, the zinc oxide thin film formed by electrodeposition from the aqueous solution containing zinc ions and nitrate ions tends to cause scattering (non-uniformity) in the size of zinc oxide crystal grains, bringing about a problem in uniformity when formed in a large area. Moreover, there has been a problem that the zinc oxide thin film formed by electrodeposition from the aqueous solution containing zinc ions and nitrate ions has an adherence to substrate which is inferior to that of the one formed by vacuum deposition utilizing resistance heating or electron beams, sputtering, ion plating, CVD or the like.

The techniques disclosed in Patent Literatures 2 and 3 have materialized a surface profile having a superior optical confinement effect, have made abnormal growth less occur and have improved uniformity, having superior characteristics as substrate members of photovoltaic devices. However, in order to attain much higher characteristics of photovoltaic devices, they have had subjects that the substrate member must have more optical confinement effect in order to obtain much higher characteristics of photovoltaic devices, that the substrate member must have much higher durability when it is deformed or cut in a post step after it has been formed, that the substrate member must be more improved also in environmental resistance under conditions of actual use, and that the substrate member must be more kept from undergoing strain after photovoltaic devices have been formed.

### SUMMARY OF THE INVENTION

The present invention was made taking account of such circumstances. Accordingly, an object of the present invention is to enable formation at a low cost, of a zinc oxide film having characteristics and durability which are much superior to those formed by any conventional methods, and to provide a photovoltaic device having high efficiency, by incorporating therein such a zinc oxide film.

The present inventors provide, as a first category of the invention, a zinc oxide film formed on a substrate;
the zinc oxide film having a plurality of texture constituents comprised of a plurality of hills each having structure wherein a first surface borders on a second surface along one curved line, where;
texture constituents in which first surfaces the hills of the texture constituents have have an average angle of inclination in a size within the range of from 30 degrees or more to 60 degrees or less and second surfaces have an average angle of inclination in a size within the range of from 10 degrees or more to 35 degrees or less account for at least a half of the plurality of texture constituents.

As a first embodiment of a second category of the invention, the present inventors provide a photovoltaic device formed by superposing a semiconductor layer on the above zinc oxide film.

In the above first category and second-category first embodiment of the invention, the first surface may preferably be formed of a curved surface, and the second surface substantially a plane surface; and the second surface may preferably be a (002)-plane of zinc oxide.

In the present invention, it is also preferable that hills the average angle of inclination of the first surfaces of which is larger than the average angle of inclination of the second surfaces account for at least a half of the plurality of texture; that hills whose projected areas of the first surfaces on the substrate are smaller than their projected areas of the second surfaces account for at least a half of the plurality of hills; and that, when the texture constituents comprised of the hills are projected on the substrate, texture constituents having lengths of from 800 nm or more to 10 µm or less in their shape on a projection chart account for at least 80% of the whole texture constituents.

The present inventors also provide, as a second embodiment of the second category of the invention, a photovoltaic device comprising a zinc oxide film and a semiconductor layer having at least one set of a p-i-n junction, wherein;
where, in respect of the light absorbed in a p-i-n junction closest to the zinc oxide film, the wavelength of light having the highest light collection efficiency is represented by X, the surface profile of the zinc oxide film on the side close to the semiconductor layer satisfies the relations of A ≥ 15° and 1 ≥ A/B ≥ 0.5 where the average angle of inclination that is found when the sampling length is set to be X is represented by A and the average angle of inclination that is found when the sampling length is set to be X/10 is represented by B.

In the above second-category second embodiment of the invention, the value A may preferably be A ≤ 40°. The A and B may also preferably satisfy the relation of 0.9 ≥ A/B ≥ 0.6. Further, at least part of the zinc oxide film may preferably be formed by electrodeposition from an aqueous solution, utilizing electrochemical reaction.

The present inventors still also provide, as a third embodiment of the second category of the invention, a photovoltaic device comprising a zinc oxide film and a semiconductor layer which have been superposed in layers;
the zinc oxide film having a plurality of hills, and hills which have a size of from 1,000 nm or more to 2,500 nm or less as average diameter found from the number of the hills per preset area and in which the ratio c of the value a of length of each hill to the value b of breadth of each hill, a/b, is within the range of 1.5 ≤ c ≤ 7 account for at least a half of the plurality of hills.

The present inventors further provide, as a fourth embodiment of the second category of the invention, a photovoltaic device comprising a zinc oxide film and a semiconductor layer having at least one set of a p-i-n junction, wherein;
the zinc oxide film has a plurality of hills on the light-incident side thereof, and the hills have angles of inclination that have two maximums in their frequency distribution.

In the above second-category fourth embodiment of the invention, the semiconductor layer having a p-i-n junction, formed on the zinc oxide film, may preferably have a plurality of hills on the light-incident side thereof, and the hills have angles of inclination that have one maximum in their frequency distribution.

In addition, in the first category to second-category fourth embodiment of the invention, at least part of the zinc oxide film may preferably be formed by electrodeposition from an aqueous solution, utilizing electrochemical reaction. The zinc oxide film may also preferably have a multi-layer structure having a first zinc oxide film formed by sputtering and a second zinc oxide film formed on the first zinc oxide film formed by electrodeposition from an aqueous solution, utilizing electrochemical reaction. The zinc oxide film may preferably comprise microcrystals.

The present inventors still further provide, as a third category of the invention, a zinc oxide film formation process which forms a zinc oxide film on a conductive substrate by immersing the conductive substrate and an opposing electrode in an aqueous solution containing at least nitrate ions, zinc ions and a polyhydric carboxylic acid, or an ester thereof, in which carboxyl groups are bonded to a plurality of carbon atoms each having an sp² hybrid orbital, followed by electrification across the conductive substrate and the opposing electrode;
the process having at least the steps of forming a zinc oxide film at a first current density and forming a zinc oxide film at a second current density.

In the third category of the invention, the second current density may preferably be higher than the first current density. Also, the zinc oxide film formed at the second current density may preferably have a thickness larger than the thickness of the zinc oxide film formed at the first current density. Further, zinc ion concentration A and nitrate ion concentration B in the aqueous solution may preferably have a relation of 2A ≤ B.

### BRIEF DESCRIPTION OF THE DRAWINGS

Fig. 1 is a diagrammatic sectional view showing an example of the photovoltaic device according to the present invention.
Fig. 2 is a diagrammatic enlarged view showing the part of a substrate member shown in Fig. 1.
Fig. 3 is a diagrammatic sectional view of a deposited-film formation system used to form substrate members in Examples and Comparative Examples.
Fig. 4 is a diagrammatic sectional view of a deposited-film formation system used to form photovoltaic devices in Examples and Comparative Examples.
Fig. 5 is a diagrammatic sectional view of a photovoltaic device formed in each of Examples 1-1 to 1-5 and Comparative Example 1-1.
Fig. 6 is a diagrammatic sectional view of a deposited-film formation system used to form substrate members in Examples and Comparative Examples.
Figs. 7A and 7B illustrate the concept of sampling length and angle of inclination.
Fig. 8 is an atomic-force microscope (AFM) image in Example 1-A.
Fig. 9 is an image showing in-plane distribution of angles of inclination, found in Example 1-A.
Fig. 10 is an atomic-force microscope (AFM) image in Comparative Example 1-A.
Fig. 11 is an image showing in-plane distribution of angles of inclination, found in Comparative Example 1-A.
Fig. 12 is a diagrammatic sectional view of a photovoltaic device formed in Example 1-6.
Fig. 13 is a view to describe how to calculate length a and breadth b.
Figs. 14A and 14B are graphs showing frequency distribution of angles of inclination of surface hills a zinc oxide film and a semiconductor layer have.
Figs. 15A and 15B are graphs showing frequency distribution of angles of inclination of surface hills a zinc oxide film and a semiconductor layer have.
Figs. 16A and 16B are graphs showing frequency distribution of angles of inclination of surface hills zinc oxide films have.

### DESCRIPTION OF THE PREFERRED EMBODIMENTS

As a result of extensive studies repeated in order to solve the problems discussed above, the present inventors have discovered that a zinc oxide film formed on a substrate; the zinc oxide film having a plurality of texture constituents comprised of a plurality of hills each having structure wherein a first surface borders on a second surface along one curved line, where texture constituents in which first surfaces the hills of the texture constituents have have an average angle of inclination in a size within the range of from 30 degrees or more to 60 degrees or less and second surfaces have an average angle of inclination in a size within the range of from 10 degrees or more to 35 degrees or less account for at least a half of the plurality of texture constituents, has a surface profile more advantageous for the optical confinement effect and has much higher durability when the substrate member is deformed or cut in a post step after it has been formed, and the photovoltaic device having this zinc oxide film has higher environmental resistance under conditions of actual use, than those of conventionally known hill-and-dale structure (textured structure) (first category and second-category first embodiment of the invention).

The present inventors have also discovered that a photovoltaic device comprising a zinc oxide film and a semiconductor layer having at least one set of a p-i-n junction, wherein, where, in respect of the light absorbed in a p-i-n junction closest to the zinc oxide film, the wavelength of light having the highest light collection efficiency is represented by X, the surface profile of the zinc oxide film on the side close to the semiconductor layer satisfies the relations of A ≥ 15° and 1 ≥ A/B ≥ 0.5 where the average angle of inclination that is found when the sampling length is set to be X is represented by A and the average angle of inclination that is found when the sampling length is set to be X/10 is represented by B, shows superior absorption characteristics especially in long wavelength regions, also has superior adherence, has much higher durability when the substrate member is deformed or cut in a post step after it has been formed, can keep the substrate member from straining after the photovoltaic device has been formed, and has higher environmental resistance under conditions of actual use, compared with conventionally known photovoltaic devices

### (second-category second embodiment of the invention).

The present inventors have still also discovered that a photovoltaic device comprising a zinc oxide film and a semiconductor layer which have been superposed in layers; the zinc oxide film having a plurality of hills, where hills which have a size of from 1,000 nm or more to 2,500 nm or less as average diameter found from the number of the hills per preset area and in which the ratio c of the value a of length of each hill to the value b of breadth of each hill, a/b, is within the range of 1.5 ≤ c ≤ 7 account for at least a half of the plurality of hills, can make the zinc oxide film have reflection characteristics more suited for the semiconductor layer, has superior adherence between the zinc oxide film and a layer adjoining thereto, and has high environmental resistance under conditions of actual use (second-category third embodiment of the invention).

The present inventors have further discovered that a photovoltaic device in which, in its semiconductor layer having a first side and a second side, the first side and the second side each have a plurality of texture constituents, where the texture constituents on the first side have angles of inclination that have two maximums in their frequency distribution and the texture constituents on the second side have angles of inclination that have one maximum in their frequency distribution, has very superior optical confinement effect and also can be improved in device characteristics without bringing about a difficulty that it triggers a shunt path, compared with conventionally known photovoltaic devices (second-category fourth embodiment of the invention).

Meanwhile, the zinc oxide film according to electrodeposition, formed by electrodeposition from the aqueous solution as disclosed in the prior art shown previously, may also have a surface profile similar to that in the present invention as being dependent on conditions. However, according to findings the present inventors have, only the fact that the surface profile is merely similar can not necessarily be optimum especially in order to bring out the optical confinement effect sufficiently, as a constituent factor of the photovoltaic device.

More specifically, it can be said to be the essence of the present invention that characteristics are much more improved by controlling within the specific ranges the angles of inclination of individual surfaces, inclusive of the proportion of the presence of such surfaces, or, where, in respect of the light absorbed in a p-i-n junction closest to the zinc oxide film, the wavelength of light having the highest light collection efficiency is represented by X, by controlling the relation between the average angle of inclination that is found when the sampling length is set to be X and the average angle of inclination that is found when the sampling length is set to be X/10.

Operations the characteristic features of the present invention exert are described below.

In order that the zinc oxide film formed on the substrate is made to have structure having good optical confinement effect, it is preferable for its surface profile to have a textured structure. Here, in order to more improve the optical confinement effect, it is optically advantageous to make relatively large the average angle of inclination of zinc oxide hill surfaces, because the optical-path length of the light reflected can be enlarged.

The present inventors have further discovered that, in order to obtain more optical confinement effect at the desired wavelength region and simultaneously obtain high characteristics required as the photovoltaic device, it is an important technical subject to control the size of hills and dales (textures) appropriately.

Stated specifically, in the photovoltaic device comprising a zinc oxide film and a semiconductor layer having at least one set of a p-i-n junction, what is preferred is one in which the scale of hill-and-dale textured profile has been controlled so that the optical confinement effect can sufficiently be brought out with respect to the wavelength region of light having the highest light collection efficiency in respect of the light absorbed in a p-i-n junction closest to the zinc oxide film. It is also simultaneously demanded that the hill-and-dale textured profile is consistent with the hill-and-dale textured profile that is necessary for sufficiently bringing out the adherence, durability and environmental resistance.

Accordingly, the present inventors have grasped the hill-and-dale textured profile of the substrate member surface in the concept of combination of hill-and-dale textured profile with a large period and hill-and-dale textured profile with a small period, and have examined from this viewpoint the hill-and-dale textured profile demanded as the photovoltaic device. As the result, they have discovered that the desired zinc oxide film can be obtained by so forming it as to control within a specific range the relationship between the sampling length and the angle of inclination; the former being the scan length in determining the angle of inclination.

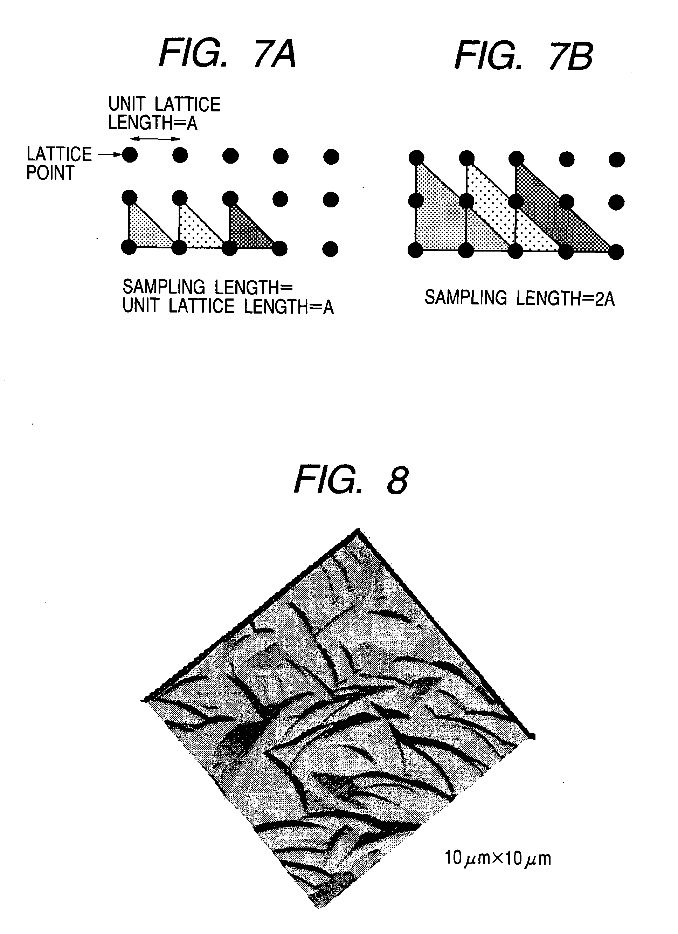

Here, an example of the concept of sampling length and angle of inclination is described with reference to Figs. 7A and 7B. First, the unit lattice length that corresponds to the minimum unit is determined. Next, lattice points are two-dimensionally disposed (black circles in Figs. 7A and 7B) within a preset range of the substrate surface at intervals of the unit lattice length, where the altitude from the standard level of each lattice point is measured by a means such as an atomic-force microscope. Next, sampling lengths consisting of arbitrary integral-fold unit lattice lengths are determined, and rectangular equilateral triangles each one side (base in the drawing) of which corresponds to the sampling length are drawn up one after another within the surface. The angles of inclination of surfaces of the individual rectangular equilateral triangles are found from height positions of lattice points corresponding to vertexes of the rectangular equilateral triangles, and an average value of the angles of inclination of all the rectangular equilateral triangles defined within the range is defined to be the average angle of inclination in the sampling lengths.

Fig. 7A shows a case in which each sampling length is set identical to the unit lattice length. The rectangular equilateral triangles defined are rectangular equilateral triangles each one side of which corresponds to the unit lattice length. The surface is entirely covered with these rectangular equilateral triangles without any overlapped part. An average value of the angles of inclination found individually from these rectangular equilateral triangles is defined to be an average angle of inclination in the case in which each sampling length is set identical to the unit lattice length. Fig. 7B also shows a case in which each sampling length is set twice the unit lattice length. The rectangular equilateral triangles defined in this case are rectangular equilateral triangles each one side of which corresponds to the twofold length of the unit lattice length. The respective rectangular equilateral triangles are disposed overlapping one another, shifting by the unit lattice length. As to the average angle of inclination in the case in which the sampling length is set twice the unit lattice length, like the case in which the sampling-length is set identical to the unit lattice length, an average value of the angles of inclination of the respective rectangular equilateral triangles is found, and this value is defined to be the average angle of inclination. Hereafter, any average angle of inclination at arbitrary sampling lengths may be defined in the same way. The size of the average angle of inclination thus defined does not reflect any hill-and-dale textured structure having a size smaller than the sampling length, and hence considered to be what represents a hill-and-dale textured structure with periods larger than the sampling length.

The first category and second-category first embodiment of the invention are described below in detail.

In the present invention, as to the average angle of inclination referred to in the first category and second-category first embodiment of the invention, the sampling lengths used as minimum units are each set to be 50 nm which is the interval corresponding to each sampling length, the lattice points are two-dimensionally disposed in a region of 20 µm × 20 µm of the measurement object surface, and the altitude from the standard level of each lattice point is measured by a means such as an atomic-force microscope. The standard level is an imaginary horizontal plane for calculating the altitude, and is an imaginary horizontal plane corresponding to a stand surface when the substrate member is placed on a horizontal stand. Next, the rectangular equilateral triangles each one side of which corresponds to the sampling length are drawn up one after another within the surface. The angles of inclination of surfaces of the individual rectangular equilateral triangles are found from height positions of lattice points corresponding to vertexes of the rectangular equilateral triangles, and an average value of the angles of inclination of all the rectangular equilateral triangles defined within the range is defined to be the average angle of inclination referred to in the present invention.

Here, as an example of structure wherein in-plane average angles of inclination are identical, between a case in which the sizes of angles of inclination in the individual regions are uniform and a case in which they are non-uniform, it is preferable that the sizes of angles of inclination in the individual regions are relatively non-uniform rather than uniform. In particular, controlling within the specific ranges the angles of inclination of individual surfaces, inclusive of the proportion of the presence of such surfaces, brings a rise in absorption of light in the photovoltaic device semiconductor layer which is an upper layer of the zinc oxide film. The present inventors have discovered this fact.

Details of the reason for this fact are unclear. It is presumed that making up such structure is effective in enlarging the optical path length of the light reflected from the zinc oxide film to the upper layer, and is preferable. In particular, a structure wherein a part having a large angle of inclination and a part having a small angle of inclination are included in a texture constituent formed of one hill brings a feature that regions having large angles of inclination and regions having small angles of inclination are present in the state they are in-plane uniformly dispersed, and hence this more brings out the optical confinement effect, as so presumed.

However, in regions having too large angles of inclination, differential regions such as sharp hills and dales are formed in the surface profile. In this case, such regions tend to be regions where abnormal growth takes place or no film formation is effected at the differential regions and in their vicinities when the upper layer is formed on the zinc oxide film. This may make the upper layer have low film characteristics, or, at the initial stage of film formation or in the course of use under conditions of actual use, may cause cracking or formation of stress concentration regions, having brought about a problem on environmental resistance. This has also brought about a problem that the substrate member may deform or the film may come off at the time of cutting. Also, in regions having too small angles of inclination, a poor optical confinement effect may result.

In a structure wherein the hill-and-dale textured profile is formed by combination of curved surfaces and plane surfaces, the effect of keeping the substrate member from causing strain or keeping the upper layer of the zinc oxide film from coming off are brought out even after the substrate member has undergone changes in heat history or steps in a high-temperature and high-humidity environment after its formation. Details are unclear why such a phenomenon comes. The present inventors presume as follows: On account of the effects such that the structure wherein curved surfaces and plane surfaces are combined has structure which can readily absorb external stress, that any sharp changes in hill-and-dale textured profile of the surface can be made gentle at the curved surfaces and that the structure wherein the inclination of hill surfaces at joint areas to the upper layer has been controlled brings an improvement in adherence, the characteristics contributory to superior environmental resistance can be achieved by providing the structure of the present invention, making the hill-and-dale textured profile develop.

Taking account of the above circumstances, the construction that, in a zinc oxide film formed on a substrate, the zinc oxide film has a plurality of texture constituents comprised of a plurality of hills each having structure wherein a first surface borders on a second surface along one curved line, where texture constituents in which first surfaces the hills of the texture constituents have have an average angle of inclination in a size within the range of from 30 degrees or more to 60 degrees or less and second surfaces have an average angle of inclination in a size within the range of from 10 degrees or more to 35 degrees or less account for at least a half of the plurality of texture constituents, makes it both possible to more improve the optical confinement effect and to keep the above problems from arising.

Incidentally, in the present invention, the hills each having structure wherein a first surface borders on a second surface along one curved line is specifically meant to be texture constituents comprised of hills each having slants on the right and left sides of a curved ridge line. The curved ridge line may preferably be an arced ridge line. The texture constituents comprised of such hills also refer to hills alone, combination of a plurality of hills, or hills standing crossed one another.

The first surfaces and second surfaces in the present invention may be either of substantially plane surfaces or curved surfaces. However, in the structure wherein curved surfaces and plane surfaces are combined, it is preferable that the first surfaces are formed of curved surfaces and the second surfaces are formed of substantially plane surfaces, because the effect of keeping the substrate member from causing strain or keeping the upper layer of the zinc oxide film from coming off are brought out even after the substrate member has undergone changes in heat history or steps in a high-temperature and high-humidity environment after its formation.

In particular, the second surfaces formed of substantially plane surfaces may each preferably be a (002)-plane of zinc oxide because in-plane cracking can be kept from occurring. Details of the reason therefor are unclear. The present inventors presume that in the zinc oxide the (002)-plane is a plane having the largest in-plane atomic density and has a small free energy, and hence the fact that the second surfaces having a small average angle of inclination and may readily show larger areas than the first surfaces are (002)-planes contributes to enhancement of the adherence to the upper layer.

In a photovoltaic device in which a silicon type semiconductor layer is superposed on the zinc oxide film, it is desirable to show effective reflection characteristics at wavelengths where absorption is small in the vicinity of band ends of semiconductor materials, i.e., at 800 to 1,200 nm. Here, a problem may arise such that, in those in which the size of the texture constituents comprised of hills is finer than the wavelength of the light to be reflected, the effect attributable to the hill-and-dale textured profile is not sufficiently brought out, and, in those in which the size is too large, the effect of irregular reflection may come small or the characteristics required as the device may lower. For example, when the upper layer is formed to make up a photovoltaic device, the photovoltaic device may have a small value of open-circuit voltage because the size of the texture constituents comprised of hills, of the zinc oxide film is relatively too smaller than the layer thickness of the semiconductor layer formed right above the texture constituents. This is considered probably due to the fact that such a size makes it unable to secure any substantial layer thickness(es) of an n-type semiconductor layer and/or p-type semiconductor layer. There arise such a problem of a lowering of characteristics. Here, providing the construction that, when the hill-and-dale textured profile of the zinc oxide film is projected on the substrate, texture constituents (hills) having lengths of from 800 nm or more to 10 µm or less in their shape on a projection chart account for at least 80% of the whole texture constituents is preferred because this makes it both possible to brought out the optical confinement effect greatly and to keep the above problems from arising.

As a method of forming the zinc oxide film which is a zinc oxide film formed on a substrate, the zinc oxide film having a plurality of texture constituents comprised of a plurality of hills each having structure wherein a first surface borders on a second surface along one curved line, where texture constituents in which first surfaces the hills of the texture constituents have have an average angle of inclination in a size within the range of from 30 degrees or more to 60 degrees or less and second surfaces have an average angle of inclination in a size within the range of from 10 degrees or more to 35 degrees or less account for at least a half of the plurality of texture constituents,
at least part of the zinc oxide film may preferably be formed by electrodeposition from an aqueous solution, utilizing electrochemical reaction. This enables profile control without employing a means such as working after film formation, compared with cases in which the film is formed by other methods such as sputtering. As will be described below, it is particularly preferable to form a second layer of the zinc oxide film by electrodeposition. In addition, an expensive oxide target and a vacuum apparatus, which are required in the sputtering, are not required in the electrodeposition, and the film can be formed at a low cost in respect of both materials and production apparatus. Hence, it is advantageous also in view of cost to form at least part of the zinc oxide film by electrodeposition.

Depending on combination of the zinc oxide film with its lower layer, it is difficult in some cases to form the zinc oxide film on its lower layer by electrodeposition, e.g., the adherence between the zinc oxide film and the lower layer must be made stronger or growth nuclei of zinc oxide may be formed with difficulty directly on the lower layer by the electrodeposition. In such cases, it is preferable that, as the zinc oxide film, a first zinc oxide film is first formed by sputtering and then a second zinc oxide film is superposed on the first zinc oxide film by the electrodeposition from the aqueous solution, utilizing electrochemical reaction, to provide a double-layer structure.

The second-category second embodiment of the invention is described below.

In consideration of the surface profile from the concept of the average angle of inclination and where, in respect of the light absorbed in a p-i-n junction closest to the zinc oxide film, the wavelength of light having the highest light collection efficiency is represented by X, the structure of A ≥ 15° where the average angle of inclination that is found at a sampling length X is represented by A has superior optical confinement effect to the light with wavelengths at which absorption is to take place, and is preferable. However, in a structure wherein the value of A is too large, differential regions such as sharp hills and dales are formed in the surface profile. In such a case, if the semiconductor layer is formed on such differential regions, the substantial layer thickness may come smaller than that in other regions because the deposition rate of film on the differential regions is relatively small or because such regions have a large surface area, bringing about a problem that no desired characteristics are obtainable. For example, where an n-type semiconductor layer or p-type semiconductor layer, which is a constituent part of the photovoltaic device, is formed on the differential regions, a problem may arise undesirably such that the substantial layer thickness of the n-type semiconductor layer or p-type semiconductor comes small to make the photovoltaic device have a small value of open-circuit voltage. Accordingly, A ≤ 40° may be given as a more preferred structure.

In order to improve the adherence between the zinc oxide film and the upper layer, the size of the average angle of inclination that is found when the sampling length is set to be less than X may have a larger value than the value of the average angle of inclination A that is found when the sampling length is set to be X. This is a preferable tendency. However, if this tendency is too large, i.e., if the development of hill-and-dale textured profile with small periods is too larger than that of hill-and-dale textured profile with large periods, regions where abnormal growth takes place or no film formation is effected tend to come when the upper layer is formed, rather resulting in a low adherence. This may make the upper layer have low film characteristics, or, at the initial stage of film formation or in the course of use under conditions of actual use, may cause cracking or formation of stress concentration regions, bringing about a problem on environmental resistance. This may also bring about a problem that the substrate member may deform or the film may come off at the time of cutting. Further, if the hill-and-dale textured profile with small periods stands developed, the internal stress of the zinc oxide film that comes from heat history in forming the upper layer may increase to cause the substrate member to undergo strain.

As a result of extensive studies made by the present inventors taking account of the foregoing, the present inventors have discovered a preferable relation between the hill-and-dale textured profile with large periods and the hill-and-dale textured profile with small periods. That is, a photovoltaic device comprising a zinc oxide film and a semiconductor layer having at least one set of a p-i-n junction, wherein, where, in respect of the light absorbed in a p-i-n junction closest to the zinc oxide film, the wavelength of light having the highest light collection efficiency is represented by X, the surface profile of the zinc oxide film on the side close to the semiconductor layer satisfies the relation that the value of A/B is 1 ≥ A/B ≥ 0.5 where the average angle of inclination that is found when the sampling length is set to be X is represented by A and the average angle of inclination that is found when the sampling length is set to be X/10 is represented by B enables achievement of hill-and-dale textured profile. In addition, in a structure which satisfies the relation of 0.9 ≥ A/B ≥ 0.6, the effect of making the substrate member have a small strain after the semiconductor layer is formed after the formation of the zinc oxide film is especially good, and this structure may be given as a more preferred structure.

Here, as to the average angle of inclination in the second-category second embodiment of the invention, the sampling lengths described previously with reference to Figs. 7A and 7B are each set to be 1/10 of the wavelength X of light having the highest light collection efficiency. Then, the lattice points are disposed in a region of 20 µm × 20 µm of the measurement object surface, and the altitude from the standard level of each lattice point is measured by a means such as an atomic-force microscope. Next, the rectangular equilateral triangles each one side of which corresponds to the sampling lengths (X and X/10) are drawn up one after another within the surface. The angles of inclination of surfaces of the individual rectangular equilateral triangles are found from height positions of lattice points corresponding to vertexes of the rectangular equilateral triangles, and an average value of the angles of inclination of all the rectangular equilateral triangles defined within the range is defined to be the average angle of inclination on the sampling lengths.

As a method of forming the zinc oxide film in which the surface profile of the zinc oxide film on the side close to the semiconductor layer satisfies the relations of A ≥ 15° and 1 ≥ A/B ≥ 0.5 where the average angle of inclination that is found when the sampling length is set to be X is represented by A and the average angle of inclination that is found when the sampling length is set to be X/10 is represented by B, at least part of the zinc oxide film may preferably be formed by electrodeposition from an aqueous solution, utilizing electrochemical reaction. This enables profile control without employing a means such as working after film formation, compared with cases in which the film is formed by other methods such as sputtering. As will be described below, it is particularly preferable to form a second layer of the zinc oxide film by electrodeposition. In addition, an expensive oxide target and a vacuum apparatus, which are required in the sputtering, are not required in the electrodeposition, and the film can be formed at a low cost in respect of both materials and production apparatus. Hence, it is advantageous also in view of cost to form at least part of the zinc oxide film by electrodeposition.

Depending on combination of the zinc oxide film with its lower layer, it is difficult in some cases to form the zinc oxide film on its lower layer by electrodeposition, e.g., the adherence between the zinc oxide film and the lower layer must be made stronger or growth nuclei of zinc oxide may be formed with difficulty directly on the lower layer by the electrodeposition. In such cases, it is preferable that, as the zinc oxide film, a first zinc oxide film is first formed by sputtering and then a second zinc oxide film is superposed on the first zinc oxide film by the electrodeposition from the aqueous solution, utilizing electrochemical reaction, to provide a double-layer structure. In this case, conditions for the second zinc oxide film may be adjusted in conformity with the materials and surface profile of the first zinc oxide film so that zinc oxide films having various surface profiles can be formed. From among these, conditions that provide the surface profile defined in the present embodiment may be selected so that the desired zinc oxide film can be obtained, and such a zinc oxide film may be used to form a photovoltaic device having superior characteristics and durability.

The second-category third embodiment of the invention is described below.

In order that the zinc oxide film formed on the substrate is made to have a structure with superior reflection characteristics, it is preferable to control its surface profile so as to have hill-and-dale textured structure with an appropriate size to provide a surface profile which enables sufficient reflection of the light with wavelengths at which reflection is to take place. Stated specifically, the zinc oxide film may preferably have a hill-and-dale textured profile on the order of the wavelengths at which reflection is to take place.

In addition, in the case when the surface is made to have the hill-and-dale textured profile as mentioned above, not only the effect of obtaining the zinc oxide film with superior reflection characteristics but also an additional effect can be brought out such that the adherence between the zinc oxide film and a layer adjoining thereto is improved. Details on this effect are unclear. The present inventors presume that, probably the controlling of the surface so as to have an appropriate hill-and-dale textured profile brings appropriate enlargement of the surface area of the zinc oxide film, so that its internal stress is relaxed. In particular, when the electrodeposition is used, in its zinc oxide film formation process, the surface diffusion of atoms in a film formation region is smaller than that in a gaseous phase process such as sputtering and vacuum deposition. Hence, the zinc oxide film formed is considered to have a relatively large internal stress because of factors such that the time by which the atoms are set into lattices is short, that trace quantities of additives and impurities contained in the aqueous solution are incorporated into the film and that the rearrangement of in-film atoms can not take place easily because film formation temperature is limited to a temperature not higher than the aqueous solution. Thus, it is considered that the effect of relaxing internal stress is especially effectively brought out when the surface has hill-and-dale textured profile than when it has plane-surface profile, and this greatly contributes to the improvement in adherence between the zinc oxide film and a layer adjoining thereto.

On the basis of the foregoing, in consideration of an appropriate zinc oxide film surface profile in a photovoltaic device formed by superposing in layers the zinc oxide film and a semiconductor layer formed of amorphous silicon hydride, amorphous silicon germanium hydride, amorphous silicon carbide hydride, microcrystalline silicon, polycrystalline silicon or the like, it can be said that it is preferable for the zinc oxide film to have a surface profile achievable of both the showing of effective reflection characteristics in a wavelength region ranging from 800 nm to 1,200 nm where the semiconductor layer has small absorption efficiency and the securing of the adherence between the zinc oxide film and a layer adjoining thereto. In order to materialize this at a higher level, it is an important technical subject that, taking note of the shape of hills of zinc oxide, the size of their average diameter and the value of the ratio of length to breadth of each hill be controlled within specific ranges, as so the present inventors have discovered. Stated specifically, they have discovered it to be a preferred embodiment that, in the photovoltaic device formed by superposing in layers a zinc oxide film and a semiconductor layer, the zinc oxide film has a plurality of hills, where hills which have a size of from 1,000 nm or more to 2,500 nm or less as average diameter found from the number of the hills per preset area and in which the ratio c of the value a of length of each hill to the value b of breadth of each hill, a/b, is within the range of 1.5 ≤ c ≤ 7 account for at least a half of the plurality of hills.

Here, the average diameter, r, found from the number of the hills per preset area may be known by counting, as number n, hills present in a preset region (e.g., a square with area c², having each side with length c) using an observable image means such as a photograph or picture making use of a microscope, and calculating from the expression r = c/ (nπ)^{½}. Similarly, the values of length a and breadth b can also be found from the observable image means. Incidentally, the average value of ridge lines of hills grasped from the observable image means is regarded as the average value of lengths. Then, the average value of breadths may be found from (average value of lengths) × (average value of breadths) = r².

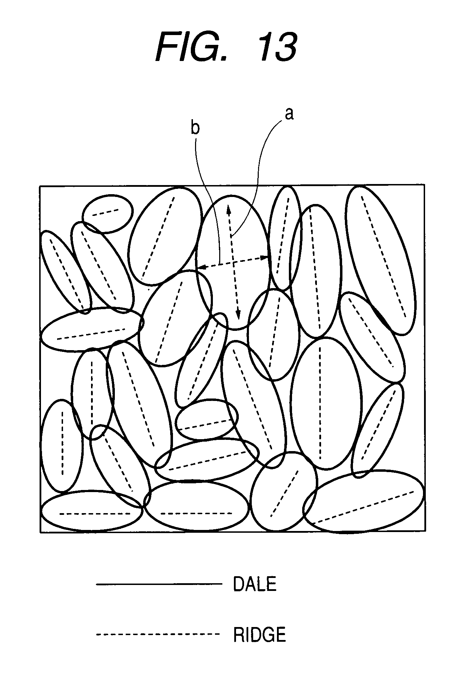

As a simpler method, a method making use of an atomic-force microscope and a control-analysis software is described with reference to Fig. 13. Lattice points are two-dimensionally disposed within a preset range of the substrate surface at intervals of the unit lattice length, where the altitude from the standard level of each lattice point is measured with the atomic-force microscope. Next, on the basis of altitude positions of the respective lattice points found, angles θ of inclination of faces of the rectangular equilateral triangles each one side of which corresponds to the unit lattice length are individually calculated. From the relation of fluctuation of the angles θ of inclination thus found, ridge lines of the surface profile are defined. The number of the ridge lines thus defined is regarded as number n of hills within the preset region, and the average diameter r is calculated from the above expression. The values of length a and breadth b can also be found by identifying the part of dales of the surface profile from the angles θ of inclination to define respective hills.

Incidentally, the average value of lengths and the average value of breadths may also be calculated according to the above way of thinking, after ridge lines have been defined from the relation of fluctuation of the angles θ of inclination. In the present specification, as the angle θ of inclination, the average diameter r, the length a, the breadth b, the average value of lengths and the average value of breadths, those which are calculated by the above simple method are employed unless particularly noted.

In the case when such a simple method is employed, the length a and average diameter r come smaller than the values in actual view. This is because the ridge line of one hill is cut at the part where hills overlap one another, and is count as a plurality of ridge lines.

As the reason why the structure is preferred wherein hills which have a size of from 1,000 nm or more to 2,500 nm or less as average diameter found from the number of the hills per preset area and in which the ratio c of the value a of length of each hill to the value b of breadth of each hill, a/b, is within the range of 1.5 ≤ c ≤ 7 account for at least a half of the plurality of hills, the present inventors consider as follows: Although some part is unclear in respect of correlations under the existing condition, the size of hills has influence on the reflection characteristics and the adherence. That is, if the size of hills is relatively small, the reflection characteristics at the desired wavelength region is insufficient. In particular, interference caused in a long-wavelength region tends to lower reflection characteristics.

On the other hand, if the size of hills is relatively large, the zinc oxide film has a larger internal stress especially when the zinc oxide film is formed in a large thickness, tending to lower its adherence to the layer adjoining thereto. On the basis of these facts, the present inventors have studied structures wherein the zinc oxide film has higher reflection characteristics and higher adherence to the layer adjoining thereto. As the result, they have discovered that, as the shape of hills, it is more desirable than a structure wherein hills are substantially elliptic in their projected areas, to afford a structure which makes each hill have such a shape that a difference is provided to a certain extent between the length a and the breadth b, so as to be able to make the most of the effect obtained because hills have large scale and the effect obtained on hills having small scale, stated specifically, the structure within the range of 1.5 ≤ c ≤ 7.

It is also known that, in a structure wherein a semiconductor layer is adjoining to a zinc oxide film whose hill-and-dale textured profile consists of inclined planes constituted of substantially plane surfaces, as typified by, e.g., pyramidal textured profile, and where the semiconductor layer is made up to contain microcrystals, the photoelectric conversion efficiency may lower in the case of substrate members making use of hill-and-dale textured profile considered from the optical confinement effect. This is considered due to the fact that, in such hill-and-dale textured profile consisting of inclined planes constituted of substantially plane surfaces, crystal grains may collide against one another especially around dales and their vicinities as the microcrystals growth, resulting in an increase in defects or imperfections thereby caused.

Here, in the surface profile disclosed in the present invention, the angles of inclination in the hills have distribution without assuming substantially a constant value, and hence the effect of restraining the formation of defects or imperfections caused by the collision of crystal grains is brought out, as so presumed. The reason therefor is considered probably due to the fact that, in the structure according to the present invention, atoms that form the semiconductor layer on the zinc oxide film adhere to the latter in different probabilities because the plane directions of zinc oxide standing exposed to the surface of the zinc oxide film are different depending on places, or because the nuclei of the semiconductor layer are non-uniformly formed on the zinc oxide film, or because the angles of planes in respect to the generatrix direction of the substrate member are different at any time during film formation.

The present inventors also presume that probably the relaxation of sharp angles of dales also brings out the effect of restraining the collision of crystal grains of the microcrystals constituting the semiconductor layer. Such effect is considered to bring an improvement in environmental resistance under conditions of actual use of the photovoltaic device. From the foregoing, it can be said that the structure according to the present invention makes it possible to provide the profile of the zinc oxide film having reflection characteristics superior to that of conventionally known structures, and when a semiconductor layer containing microcrystals is formed on the zinc oxide film to produce a photovoltaic device, more excellent semiconductor layer can be obtained.

The second-category fourth embodiment of the invention is described below.

In order to solve the problems discussed previously, the present inventors have made studies taking note of not only the average value of angles of inclination of the hills in the surface profile of the zinc oxide film but also the frequency distribution of angles of inclination. As the result, they have discovered the following: In respect of the semiconductor layer on the zinc oxide film side of which the surface profile of the zinc oxide film has been taken over, a feature that the frequency distributions of angles of inclination of texture constituents at both interfaces (both sides) of the semiconductor layer differ greatly and further a feature that the number of maximum of the frequency distribution the angles of inclination of the texture constituents have differs for each side bring out superior optical confinement effect and bring a more improvement in device characteristics.

However, the frequency distribution of angles of inclination of the texture constituents is mostly broad, and in fact can be deemed to be synthesis of a plurality of distributions. In the present invention, it is not the case that any difference in angles of distribution centers of such a plurality of distributions is discussed. What has been discovered is that the features that the distribution is clearly different and the number of maximum of frequency distribution is different have influence on the characteristics. In particular, as characteristic features of the frequency distribution of angles of inclination of the texture constituents on the zinc oxide film side surface (hereinafter first side) (i.e., the hills of the zinc oxide film's light-incident side surface) and that of the light-incident side surface (hereinafter second side), the former has two maximums in frequency distribution and the latter one maximum, in the case of which superior optical confinement effect has been ascertained.

Here, as the definition of the maximum of frequency distribution of angles of inclination, the frequency distribution function of angle θ is regarded as f(θ), where, when there are two peaks (curved upward) of its quadratic differential, the frequency distribution function f(θ) is defined to have one maximum. Then, when there are three or four peaks of quadratic differential, the frequency distribution function f(θ) is defined to have two maximums. Of course, in performing differentiation, spikes and micropeaks both regarded as noise components in measuring the frequency distribution function f(θ) are removed by smoothing.

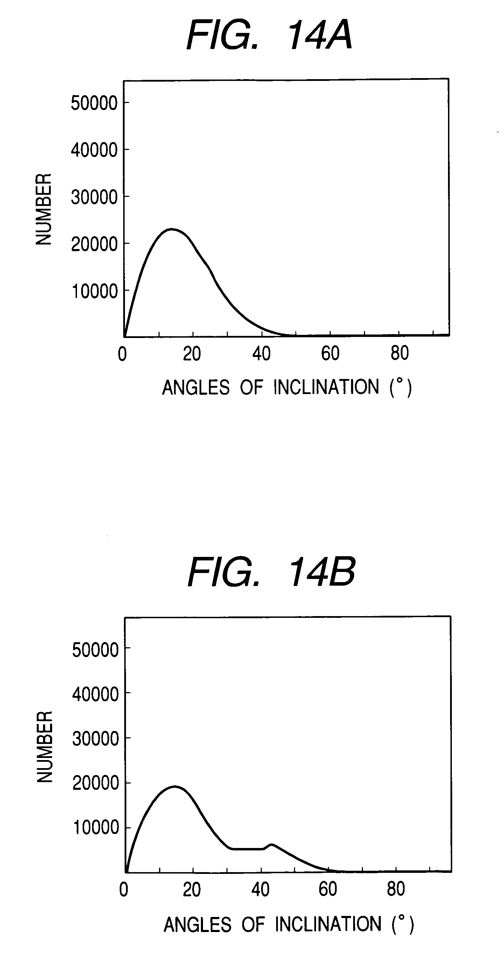

As to the respective central values of the two maximums in frequency distribution thus obtained in respect of the angles of inclination of the hills of the zinc oxide film's light-incident side surface constituted of a plurality of hills, it is desirable that one is present at 5 degrees or more to 35 degrees or less and the other is present at 30 degrees or more to 70 degrees or less, both from the side with low angles (see Fig. 14B as an example).

In order to make the semiconductor layer have on its both sides surface profiles having superior optical confinement effect, it is preferable to make the surface profiles on both sides have hill-and-dale textured profile. Here, in the case when it has been intended to make the optical confinement effect maximum by forming the hill-and-dale textured profile only on the underlying (subbing) layer of the semiconductor layer, it has been necessary to enlarge the average angle of inclination of the hills of the underlying layer. However, in regions where the angles of inclination are too larger the differential regions such as sharp hills and dales are inevitably formed in the surface profile. If the upper layer is formed on such differential regions, this may make the upper layer have low film characteristics, or, at the initial stage of film formation or in the course of use under conditions of actual use, may cause cracking or formation of stress concentration regions, having brought about a problem on environmental resistance, because, e.g., abnormal growth takes place or no film formation is effected at the differential regions and in their vicinities.

Accordingly, the present inventors have made extensive studies. As the result, they have discovered that the proper range of the average angle of inclination on each side for the purpose of enhancing the optical confinement effect of confining light within the semiconductor layer held between the first side and the second side can be broadened by forming the semiconductor layer in such a way that its first-side and second-side both sides have different frequency distributions of angles of inclination, and that such superior optical confinement effect can be obtained also by combination of a surface having angles of inclination at lower degrees. Stated specifically, they have discovered that, when one side has a structure wherein the frequency distribution of angles of inclination has two maximums and the other side has a structure wherein the frequency distribution of angles of inclination has one maximum, the optical confinement effect in the semiconductor layer is dramatically improved in virtue of the restraint of interfering behavior of light, compared with a structure wherein the number of maximum(s) of the frequency distribution of angles of inclination is equal on both sides. As the result, it has been made both possible to control the problems concerning the environmental resistance, to a level of no problem in practical use and to achieve high characteristics as the photovoltaic device simultaneously with the superior optical confinement effect.

As to the angles of inclination referred to in the second-category fourth embodiment of the invention, in Fig. 7A, the sampling lengths used as minimum units are each set to be 50 nm which is the interval corresponding to each sampling length, the lattice points are two-dimensionally disposed in a region of 20 µm × 20 µm of the measurement object surface, and the altitude from the standard level of each lattice point is measured by a means such as an atomic-force microscope. Next, the rectangular equilateral triangles each one side of which corresponds to the sampling length are drawn up one after another within the surface. The angles of inclination of surfaces of the individual rectangular equilateral triangles are obtained by finding the angles of inclination of all the rectangular equilateral triangles defined within the range, from height positions of lattice points corresponding to vertexes of the rectangular equilateral triangles.

In order to obtain the surface profile of the semiconductor layer, shown in the present embodiment, it is possible to use a method in which the semiconductor layer is formed on the underlying layer having two maximums in frequency distribution of angles of inclination, or to take a means such as the etching of the first side and second side of the semiconductor layer. Further, it is also possible to form the semiconductor layer utilizing as its underlying layer the zinc oxide film formed by electrodeposition, followed by the etching of the zinc oxide film underlying layer.

As a method of forming the zinc oxide film of the present embodiment, at least part of the zinc oxide film may preferably be formed by electrodeposition from an aqueous solution, utilizing electrochemical reaction. This enables profile control without employing a means such as working after film formation, compared with cases in which the film is formed by other methods such as sputtering. As will be described below, it is particularly preferable to form a second layer of the zinc oxide film by electrodeposition. In addition, an expensive oxide target and a vacuum apparatus, which are required in the sputtering, are not required in the electrodeposition, and the film can be formed at a low cost in respect of both materials and production apparatus. Hence, it is advantageous also in view of cost to form at least part of the zinc oxide film by electrodeposition.

Depending on combination of the zinc oxide film with its lower layer, it is difficult in some cases to form the zinc oxide film on its lower layer by electrodeposition, e.g., the adherence between the zinc oxide film and the lower layer must be made stronger or growth nuclei of zinc oxide may be formed with difficulty directly on the lower layer by the electrodeposition. In such cases, it is preferable that, as the zinc oxide film, a first zinc oxide film is first formed by sputtering and then a second zinc oxide film is superposed on the first zinc oxide film by the electrodeposition from the aqueous solution, layer structure. In this case, conditions for th5e second zinc oxide film may be adjusted in conformity with the materials and surface profile of the first zinc oxide film so that zinc oxide films having various surface profiles can be formed. From among these, conditions that provide the surface profile defined in the present embodiment may be selected so that the desired zinc oxide film can be obtained, and such a zinc oxide film may be used to form a photovoltaic device having superior characteristics and durability.

The present invention is described below in greater detail.

Components of the photovoltaic device of the present invention are described first.

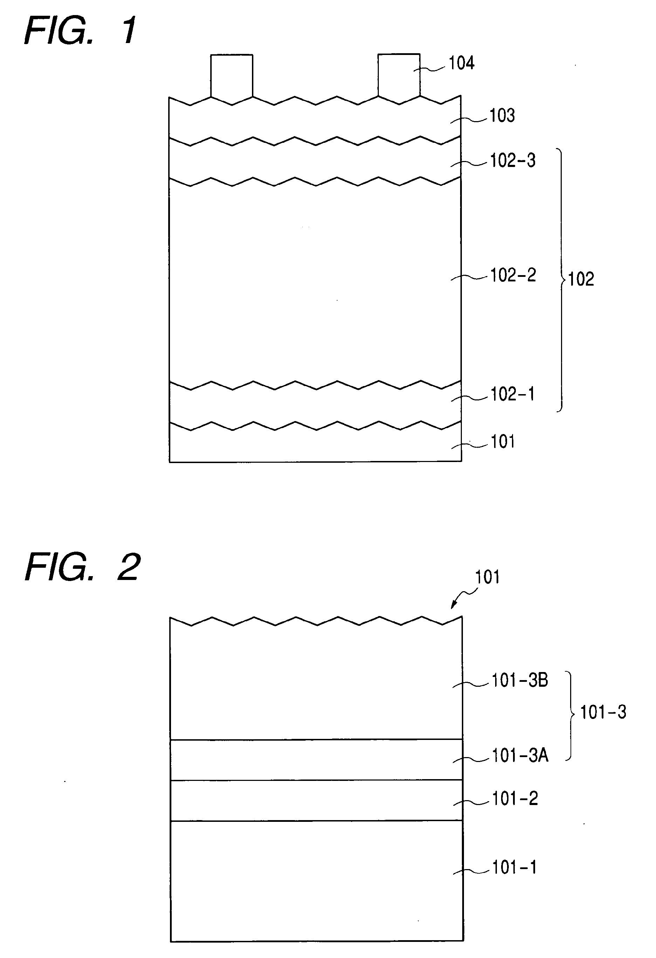

Figs. 1 and 2 are diagrammatic sectional views showing an example of a photovoltaic device and a substrate member constituting the photovoltaic device, respectively. In Figs. 1 and 2, reference numeral 101 denotes a substrate member (a substrate on which some film(s) has/have been formed); 102, a semiconductor layer, in which 102-1 denotes an n-type semiconductor layer, 102-2 an i-type semiconductor layer, and 102-3 a p-type semiconductor layer; 103, a transparent conductive layer; and 104, a collector electrode. Also, reference numeral 101-1 denotes a substrate (substrate per se); 101-2, a reflecting layer; and 101-3, a first transparent conductive layer, in which 101-3A denotes a first zinc oxide film, and 101-3 a second zinc oxide film. These constitute the substrate member 101. The reflecting layer may optionally be formed.

### (Substrate 101-1)

As the substrate 101-1, a plate-like member or sheet-like member formed of metal, resin, glass, ceramic or semiconductor bulk may preferably be used. Its surface may have fine unevenness. The substrate 101-1 may be constituted of a transparent material so that the light can enter on the substrate side. The substrate may also have the form of a continuous sheet so that films can continuously be formed by the roll-to-roll method. In particular, a material having a flexibility, such as stainless steel or polyimide, is preferable as the material for the substrate 101-1.

### (Reflecting Layer 101-2)

The reflecting layer 101-2 has the function as an electrode and the function to reflect the light having reached the substrate 101-1 reflects, so as to be again utilized in the semiconductor layer 102. As materials therefor, Al, Cu, Ag, Au, CuMg and AlSi, or an alloy of any of these may preferably be used. The reflecting layer 101-2 may also be formed in a multi-layer structure in combination with a transition metal such as Ni, Cr or Ti, which may preferably be used. The effect of more improving adherence between the substrate 101-1 and the reflecting layer 101-2 can be expected. As processes for its formation, processes such as vacuum deposition, sputtering, electrodeposition and printing may preferably be used. The reflecting layer 101-2 may preferably have unevenness at its surface. This can make the reflected light have a larger optical-path length in the semiconductor layer 102 to make short-circuit current larger.

### (Zinc Oxide Film 101-3)

The zinc oxide film 101-3 has the function to make the reflected light have a larger optical-path length in the semiconductor layer 102. It also has the function to cause the element of the reflecting layer 101-2 to diffuse or migrate to the semiconductor layer 102 to prevent the photovoltaic device from shunting. Where it has an appropriate resistance, it still also has the function to prevent the photovoltaic device from causing a short circuit due to some defects such as pinholes of the semiconductor layer. The zinc oxide film 101-3 has the surface profile according to the present invention.

More specifically, in the first category and second-category first embodiment of the invention, the zinc oxide film has a plurality of texture constituents comprised of a plurality of hills each having structure wherein a first surface borders on a second surface along one curved line, and texture constituents in which first surfaces the hills of the texture constituents have have an average angle of inclination in a size within the range of from 30 degrees or more to 60 degrees or less and second surfaces have an average angle of inclination in a size within the range of from 10 degrees or more to 35 degrees or less may preferably account for at least a half of the plurality of texture constituents.

In the second-category second to fourth embodiments of the invention, the zinc oxide film 101-3 may preferably have a structure wherein, where, in respect of the light absorbed in a p-i-n junction closest to the zinc oxide film, the wavelength of light having the highest light collection efficiency is represented by X, the surface profile of the zinc oxide film 101-3 on the side close to the semiconductor layer 102 satisfies the relations of A ≥ 15° and 1 ≥ A/B ≥ 0.5 where the average angle of inclination that is found when the sampling length is set to be X is represented by A and the average angle of inclination that is found when the sampling length is set to be X/10 is represented by B.

To form the above surface profile, at least part of the zinc oxide film 101-3 may preferably be formed by electrodeposition from an aqueous solution, utilizing electrochemical reaction, because this enables profile control without employing a means such as working after film formation.

As to conditions for forming the zinc oxide film 101-3 by electrodeposition, an aqueous solution containing nitrate ions and zinc ions may preferably be used in a corrosion-resistant vessel. The nitrate ions and zinc ions may preferably be in a concentration within the range of from 0.002 mol/l to 2.0 mol/l, more preferably within the range of from 0.01 mol/l to 1.0 mol/l, and still more preferably within the range of from 0.1 mol/l to 0.5 mol/l. Feed sources of the nitrate ions and zinc ions may be, but are not particularly limited to, zinc nitrate, which is a feed source for the both ions, or a mixture of a water soluble nitrate such as ammonium nitrate, which is a feed source for the nitrate ions, and a zinc salt such as zinc sulfate, which is a feed source for the zinc ions.

In order to control any abnormal growth or improve adherence, it is also preferable to further add a carbohydrate such as sucrose or dextrin to the aqueous solution. However, an excess carbohydrate is not preferable because it may make zinc oxide strongly act to fix to its C-axis orientation, to make the surface profile flat. In view of the above, the carbohydrate in the aqueous solution may preferably be in an amount, which depends on the type of the carbohydrate, within the range of from 1 g/l to 500 g/l, and more preferably from 3 g/l to 100 g/l, in the case of sucrose; and in an amount of from 0.01 g/l to 10 g/l, and more preferably from 0.025 g/l to 1 g/l, in the case of dextrin.

Details being unclear as to the effect and its mechanism, it is preferable to introduce into the aqueous solution a polyhydric carboxylic acid, or an ester thereof, in which carboxyl groups are bonded to a plurality of carbon atoms each having an sp² hybrid orbital, for the purpose of controlling the size of the texture constituents of hill-and-dale textured profile or controlling the angles of inclination of the texture constituents. The polyhydric carboxylic acid, or an ester thereof, in which carboxyl groups are bonded to a plurality of carbon atoms each having an sp² hybrid orbital may include those having a -C=C- group to each carbon atoms of which a carboxyl group or an ester group has been bonded, and those having an aromatic ring (such as a benzene ring or a heterocyclic group) to a plurality of carbon atoms of which carboxyl groups have been bonded. Stated more specifically, it may include phthalic acid, isophthalic acid, maleic acid and naphthalic acid, or esters of these. However, an excess polyhydric carboxylic acid is not preferable because it may act to make the zinc oxide film have too fine hill-and-dale textured profile. In view of the above, the polyhydric carboxylic acid may preferably be used in a concentration of from 0.5 to 500 µmol/l, and more preferably from 10 to 300 µmol/l. Incidentally, the concentration of the polyhydric carboxylic acid is what represents total concentration of the polyhydric carboxylic acid and its carboxylate anion or the like.

In the case when the zinc oxide film 101-3 is formed by electrodeposition, in the above aqueous solution, a substrate 101-1 on which the zinc oxide film 101-3 is to be deposited may preferably be set as the cathode, and zinc, platinum, carbon or the like as the anode. Electric current which flows across the anode and the cathode may preferably be at a value within the range of from 0.1 mA/cm² to 100 A/cm², more preferably from 1 mA/cm² to 30 A/cm², and most preferably from 4 mA/cm² to 20 A/cm².

In the case when the zinc oxide film 101-3 is formed by electrodeposition, the shape and orientativity of the zinc oxide to be formed can be controlled by controlling the concentration of nitrate ions and zinc ions in the aqueous solution, the temperature of the aqueous solution, the pH of the aqueous solution, the manner of stirring the aqueous solution, and additives such as the carbohydrate and the polyhydric carboxylic acid. However, the surface profile of the zinc oxide film 101-3 is influenced by, in addition to the conditions for the electrodeposition described above, the material and surface profile of the substrate 101-1, whether or not the reflecting layer 101-2 is present, and the material and surface profile of the reflecting layer 101-2. Further, where the zinc oxide film 101-3 is formed in a multi-layer structure wherein, on a first zinc oxide film 101-3A formed by sputtering, a second zinc oxide film 101-3B is formed by electrodeposition from the aqueous solution, utilizing electrochemical reaction, the surface profile of the second zinc oxide film 101-3B formed by electrodeposition is influenced also by the surface profile and layer thickness as well, of the first zinc oxide film 101-3A.

Accordingly, to form the surface profile of the present invention, appropriate ranges may be selected from among the above ranges in conformity with the respective embodiments so as to afford the surface profile of the present invention, to carry out the film formation. For example, it may be devised that a sample is prepared controlling the above parameters appropriately and its surface is observed on an atomic-form microscope or the like to ascertain the surface profile, and the film formation is so carried out as to regulate optimum parameters.

For example, the controlling of current density with time to form the zinc oxide film is very important for forming the desired zinc oxide film. In the zinc oxide film formation process carried out to form the zinc oxide film, the desired surface profile can more uniformly be formed by providing the step of forming the film at a first current density and the step of forming the film at a second current density. The step of forming the film at a first current density may be the step of forming an initial film uniformly, and the step of forming the film at a second current density may be the step of forming the desired hill-and-dale textured profile. The present inventors consider that these two steps in combination may be carried out at least at the initial stage when the zinc oxide film is formed by electrodeposition, and that this enables formation of the desired zinc oxide film. The second current density may preferably be higher than the first current density. More preferably, the second current density may be at least twice the first current density. The zinc oxide film formed at the second current density may preferably be in a thickness larger than the thickness of the first current density formed at the first current density. The zinc oxide film formed at the second current density may preferably be in a thickness at least 10 times the thickness of the first current density formed at the first current density.

In addition, the relation between zinc ion concentration A and nitrate ion (NO₃⁻) concentration B may preferably be 2A ≤ B because the desired zinc oxide film can be obtained. Details of the reason therefor are still unclear. The present inventors consider that the reason is probably as follows: If the value of the zinc ion concentration in respect to the nitrate ion concentration is larger beyond the above relation, electrochemical reaction in the solution accompanying oxidation reaction of zinc is somewhat effected, so that no uniform zinc oxide film is obtained. Also, if it is attempted to increase the rate of formation of the zinc oxide film, abnormal growth is brought about due to generation of abrupt increased area in zinc oxide nuclei formation density, or makes small effects necessary to form desired zinc oxide film, i.e., the extent to which the abnormal growth is restrained that is caused by the polyhydric carboxylic acid (e.g., phthalic acid), or an ester thereof, in which carboxyl groups are bonded to a plurality of carbon atoms each having an sp² hybrid orbital or by the carbohydrate (e.g., dextrin) or the extent to which the effect of enlarging grain diameter or forming hill-and-dale texture is brought out.

Conditions for forming the first zinc oxide film 101-3A by sputtering are greatly influenced by processes, types and flow rates of gases, internal pressure, electric power to be applied, film formation rate, substrate temperature and so forth. For example, where the zinc oxide film 101-3A is formed by DC magnetron sputtering and using a zinc oxide target, the types of gases may include Ar, Ne, Kr, Xe, Hg and O₂. The flow rates may differ depending on the size of apparatus and on evacuation rate, and may preferably be from 1 cm³/min (normal) to 100 cm³/min (normal) when, e.g., the film formation space has a volume of 20 liters. Also, the internal pressure at the time of film formation may preferably be from 10 mPs to 10 Pa. The electric power to be applied, which depends on the size of the target, may preferably be from 10 W to 10 kW. Also, the substrate temperature may differ in preferable ranges, depending on the film formation rate, and may preferably be from 70°C to 450°C.

### (Substrate Member 101)

By the process described above, the reflecting layer 101-2 (optional) and the zinc oxide film 101-3 are superposed in layers on the substrate 101-1 to form the substrate member 101. In order to make the integration of the device easy, an insulating layer may also be provided in the substrate member 101.

### (Semiconductor Layer 102)

As a chief material when a silicon type thin film is used in the semiconductor layer 102, an amorphous silicon or crystal silicon or further a mixed-phase system thereof is used. In place of silicon, an alloy of silicon with carbon (C) or with germanium (Ge) may be used. The semiconductor layer 102 is simultaneously incorporated with hydrogen atoms and/or halogen atoms, which may preferably be in a content of from 0.1 to 40 atomic %. The semiconductor layer 102 may further incorporated with oxygen atoms, nitrogen atoms and so forth. To form the semiconductor layer 102 as a p-type semiconductor layer, a Group III element is incorporated, and to form it as an n-type semiconductor layer a Group V element. As electrical properties of the p-type layer and n-type layer, they may preferably be those having an activation energy of 0.2 eV or below, and most preferably 0.1 eV or below. As specific resistance, it may preferably be 100 Ω·cm or below, and most preferably 1 Q·cm or below.

In the case of a stacked cell (a photovoltaic device having a plurality of p-i-n junctions), the i-type semiconductor layer 102-2 in a p-i-n junction close to the light-incident side may preferably have a broad band gap and have a band gap which is narrower in a farther p-i-n junction. In the interior of the i-type semiconductor layer 102-2, it is preferable that the maximum value of the band gap is present at a part nearer to the p-type semiconductor layer 102-3 rather than the middle in layer thickness direction. It is suitable for a doped layer (p-type semiconductor layer 102-3 or n-type semiconductor layer 102-1) on the light-incident side to be formed of a crystalline semiconductor less absorptive of light or a semiconductor having a broad band gap.

As an example of a stacked cell in which two p-i-n junctions have been superposed, it may include, as combination of i-type semiconductor layers, a cell having (amorphous semiconductor layer/semiconductor layer containing crystal phases), (semiconductor layer containing crystal phases/semiconductor layer containing crystal phases) and (amorphous semiconductor layer/amorphous semiconductor layer) from the light-incident side.

As an example of a stacked cell in which three p-i-n junctions have been superposed, it may include, as combination of i-type semiconductor layers, a cell having (amorphous semiconductor layer/amorphous semiconductor layer/semiconductor layer containing crystal phases), (amorphous semiconductor layer/semiconductor layer containing crystal phases/semiconductor layer containing crystal phases) and (semiconductor layer containing crystal phases/semiconductor layer containing crystal phases/semiconductor layer containing crystal phases) from the light-incident side.

The i-type semiconductor layer may preferably have an absorptivity coefficient (α) of light (630 nm) of 5,000 cm-1 or more, a light conductivity (σp) of 10 × 10⁻⁵ S/cm or more and a dark conductivity (σd) of 10 × 10⁻⁶ S/cm or less under irradiation by solar simulator light using a solar simulator (AM 1.5, 100 mW/cm²), and an Urbach energy of 55 meV or below according to the constant photocurrent method (CPM). As the i-type semiconductor layer, a layer slightly made into p-type or n-type may also be used.

### (Process of Forming Semiconductor Layer 102)

To form the above semiconductor layer 102, high-frequency plasma-assisted CVD is suited. A preferred example of the procedure to form the semiconductor layer 102 by the high-frequency plasma-assisted CVD is shown below.

The inside of a deposition chamber (vacuum chamber) that can be brought into a vacuum is evacuated to a stated deposition pressure.

Processing gases such as source gas and a dilute gas are introduced into the deposition chamber, and the inside of the deposition chamber is evacuated by means of a vacuum pump, in the course of which the inside of the deposition chamber is set to a stated deposition pressure.

The substrate member 101 is heated to a stated temperature by means of a heater.

High-frequency power produced by a high-frequency power source is introduced into the deposition chamber. It may be introduced into the deposition chamber by a method in which the high-frequency power is guided through a waveguide and is introduced into the deposition chamber via a dielectric window made of alumina ceramic or the like, or a method in which the high-frequency power is guided through a coaxial cable and is introduced into the deposition chamber via a metal electrode.

Plasma is caused to take place in the deposition chamber to decompose the source gas to form a deposited film on the substrate member 101 placed in the deposition chamber. This procedure is optionally repeated a plurality of times to form the semiconductor layer 102.

The semiconductor layer 102 may be formed under conditions of a substrate temperature of from 100°C to 450°C, a pressure of from 50 mPa to 1,500 Pa and a high-frequency power of from 0.001 W/cm³ to 1 W/cm³ in the deposition chamber, which are given as preferred conditions.

As source gases suited for the formation of the semiconductor layer 102, they may include gasifiable compounds containing silicon atoms, such as SiH₄, Si₂H₆ and SiF₄. Where alloy type layers are formed, gasifiable compounds containing Ge or C, such as GeH₄ and CH₄ may preferably be added to the source gases. The source gases may preferably be introduced into the deposition chamber after they have each been diluted with a diluting gas. The diluting gas may include H₂ and He. A gasifiable compound containing nitrogen, oxygen or the like may further be used as the material gas or dilute gas. As a dopant gas for making the semiconductor layer 102 into a p-type layer, B2H₆, BF₃ or the like may be used. Also, as a dopant gas for making the semiconductor layer into an n-type layer, PH₃, PF₃ or the like may be used. Where crystal-phase thin layers and layers less absorptive of light or having a broad band gap are deposited, it is preferable that the dilute gas is used in a larger proportion with respect to the source gas and high-frequency power having a relatively high power is introduced.

### (Transparent Conductive Layer 103)

The transparent conductive layer 103 serves as an electrode on the light-incident side, and also its layer thickness may appropriately be controlled so that it can also have the function of a reflection preventive layer. The transparent conductive layer 103 is required to have a high transmittance in the wavelength region of the light the semiconductor layer 102 can absorb and have a low resistivity. It may preferably have a transmittance of 80% or more, and more preferably 85% or more, at 550 nm. As materials for the transparent conductive layer 103, ITO, ZnO and In₂O₃ may preferably be used. As processes for its formation, processes such as vacuum deposition, CVD, spraying, spinning-on and dipping are preferred. A substance which changes conductivity may also be added to the above materials.

### (Collector Electrode 104)

The collector electrode 104 is provided on the transparent conductive layer 103 in order to improve electricity collection efficiency. It may be formed by a method in which a metal having an electrode pattern is formed by sputtering using a mask, a method in which a conductive paste or solder paste is printed, or a method in which a metal wire is fixed with a conductive paste; any of which is preferred.

A protective layer may also optionally be formed on each side of the photovoltaic device. At the same time, a reinforcing material such as a steel sheet may be used in combination, on the back (the side opposite to the light-incident side) of the photovoltaic device.

### EXAMPLES

In the following examples, the present invention is described in greater detail taking the case of a solar cell as the photovoltaic device. These examples by no means limit the subject matter of the present invention.

### (Example 1-1 and Comparative Example 1-1)

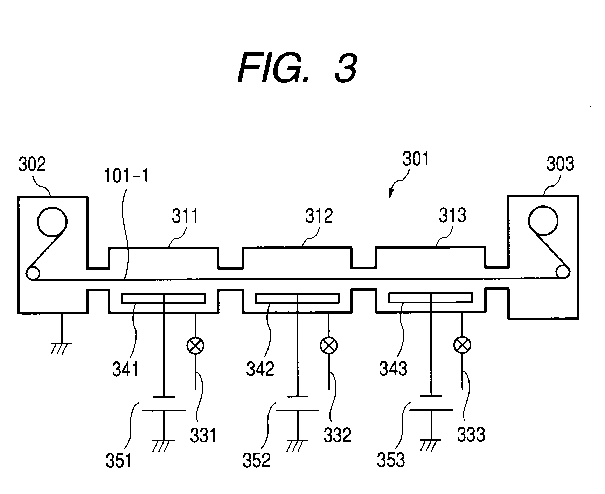

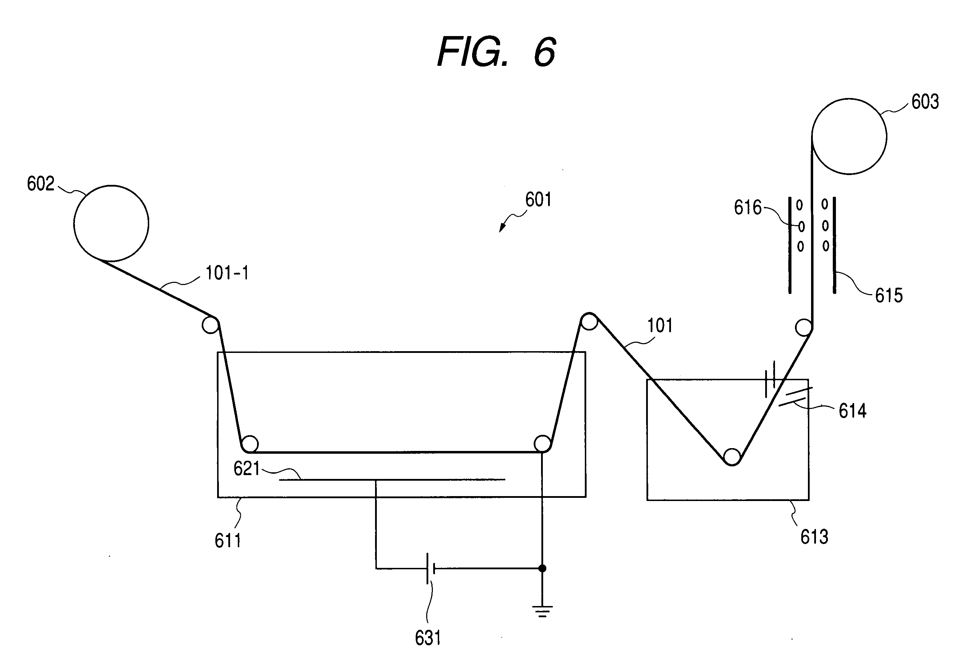

First, a beltlike substrate 101-1 (width: 40 cm, length: 200 m thickness 0.125 mm) made of stainless steel (SUS430-BA) was thoroughly degreased and cleaned. Using this substrate, the substrate member 101 shown in Figs. 1 and 2 having a reflecting layer 101-2 formed of Ag, a first zinc oxide film 101-3A formed of ZnO and a second zinc oxide film 101-3B formed of ZnO was produced by means of deposited-film-forming apparatus 301 and 601 shown in Fig. 3 and Fig. 6, respectively.

Fig. 3 is a diagrammatic sectional view showing an example of a deposited-film-forming apparatus for producing the substrate member of the photovoltaic device of the present invention. The deposited-film-forming apparatus 301 shown in Fig. 3 is constituted of a wind-off container 302, vacuum reactors 311 to 313 and a wind-up container 303, which are joined via gas gates. In this deposited-film-forming apparatus 301, the beltlike substrate 101-1 is so set as to extend through each film-forming container and each gas gate. The beltlike substrate 101-1 is wound off from a bobbin provided in the wind-off container 302, and is wound up on another bobbin in the wind-up container 303.

In the vacuum reactors 311 to 313, targets are set as cathode electrodes 341 to 343, respectively. Electric power is applied from direct-current power sources 351 to 353 to the cathode electrodes 341 to 343 to effect sputtering so that the reflecting layer 101-2 and the first zinc oxide film 101-3A can be formed on the substrate 101-1. To the vacuum reactors 311 to 313, gas feed pipes 331 to 333 are connected through which sputtering gas are fed into the containers. The vacuum reactors 311 to 313 are each also provided with a film formation region regulation plate (not shown) for regulating the area of contact of the substrate with each discharge space so that the layer thickness of deposited films formed in the vacuum reactors 311 to 313 can be regulated.

First, the substrate 101-1 was set in the deposited-film-forming apparatus 301, and the inside of the deposited-film-forming apparatus 301 was sufficiently evacuated.

Next, making an evacuation system operate, sputtering gas was fed through the gas feed pipes 331 to 333. In this state, the evacuation capacity of the evacuation system was regulated to regulate the pressure inside the vacuum reactors 311 to 313 to stated pressure. Film-forming conditions were as shown in Table 1.

**Table 1**

| Film-forming conditions | |
|---|---|
| Vacuum reactor 311 | |
| Source gas: | Ar: 50 cm³/min (normal) |
| Substrate temperature: | 450°C |
| Internal pressure: | 0.4 Pa |
| Sputtering power: | 2.0 kW |

| Vacuum reactor 312 | |
|---|---|
| Source gas: | Ar: 50 cm³/min (normal) |
| Substrate temperature: | 300°C |
| Internal pressure: | 0.4 Pa |
| Sputtering power: | 3.0 kW |

| Vacuum reactor 313 | |
|---|---|
| Source gas: | Ar: 50 cm³/min (normal) |
| Substrate temperature: | 300°C |
| Internal pressure: | 0.4 Pa |
| Sputtering power: | 3.0 kW |

At the time the pressure inside the vacuum reactors 311 to 313 became stable, the substrate 101-1 was started to move from the wind-off container 302 toward the wind-up container 303. Making the substrate 101-1 moving, infrared lamp heaters provided in the vacuum reactors 311 to 313 was made to operate to regulate film-forming surface temperature of the substrate 101-1 to come to be the value shown in Table 1. In the cathode electrode 341, silver target with a purity of 99.99% was used. In the cathode electrodes 342 and 343, zinc oxide target with a purity of 99.99% was used. To each of the cathode electrodes 341 to 343, sputtering power shown in Table 1 was applied to effect sputtering. Thus, on the substrate 101-1, a reflecting layer 101-2 formed of silver (thickness: 800 nm) was deposited in the vacuum reactor 311, and a first zinc oxide film 101-3A (thickness: 300 nm) in the vacuum reactors 321 and 313.

Next, a second zinc oxide film 101-3B was formed by means of the deposited-film-forming apparatus 601 shown in Fig. 6.

Fig. 6 is a diagrammatic sectional view showing an example of a deposited-film-forming apparatus for producing the substrate member of the photovoltaic device of the present invention. The deposited-film-forming apparatus 601 shown in Fig. 6 is constituted of a wind-off roller 602, a film-forming container 611, a water washing container 613, a drying unit 615 and a wind-up roller 603, which are joined via gas gates. In this deposited-film-forming apparatus 601, the beltlike substrate 101-1 with the reflecting layer and the first zinc oxide film is so set as to extend through each container and the drying unit. This beltlike substrate 101-1 is wound off from a bobbin provided in the wind-off roller 602, and is wound up on another bobbin in the wind-up roller 603.

In the film-forming container 611, an opposing electrode 621 of zinc is provided. This opposing electrode 621 is connected with a load resistor (not shown) and a power source 631. Also, using a heater and a thermocouple (both not shown), the temperature of an aqueous solution held in the film-forming container 611 is monitored with stirring so that the temperature of the solution can be regulated. In the washing container 613, the aqueous solution adhering to the surface of the substrate member 101 is washed away using an ultrasonic device (not shown). On the outlet side of the washing container 613, pure-water washing is carried out by means of a pure-water shower 614. In the drying unit 615, the substrate member 101 is heated with an infrared heater 616 so that the former's surface can be pre-dried.

The aqueous solution in the film-forming container 611 was made to have a zinc ion concentration of 0.1 mol/l, a pH of 5.0, an aqueous-solution temperature of 85°C, an anode-to-cathode flowing current value of 8.0 mA/cm², a dextrin concentration of 0.15 g/l, and a phthalic-acid concentration of 40 µmol/l by adding potassium hydrogen phthalate. Then the transport of the substrate 101-1 having the reflecting layer 101-2 and the first zinc oxide film 101-3A was started to carry out formation of the second zinc oxide film 101-3B, (thickness: 2.7 µm) to make up the substrate member 101. The substrate member 101 passed through the pure-water shower 614 and drying unit 615 and then wound up on the wind-up roller 603 was put into a drying container (not shown) connected to a vacuum pump, where the substrate member 101 was dried at an environmental temperature of 250°C for 5 hours in a 10 kPa atmosphere of nitrogen to complete the substrate member 101 (Example 1-1A).

The surface state of the substrate member 101 thus formed was observed using an atomic-force microscope (AFM). As shown in Fig. 7A, inner regions of the surface of the zinc oxide film were marked off with lattice points disposed at intervals each corresponding to the sampling length as one unit. The inner regions were covered with minimum triangles formed from the lattice points. From the values of inclination of the triangles, the value of average angle of inclination in the inner regions and the distribution of angles of inclination as well as the shape of the texture constituents comprised of hills were found. The sampling length was 50 nm as described previously.

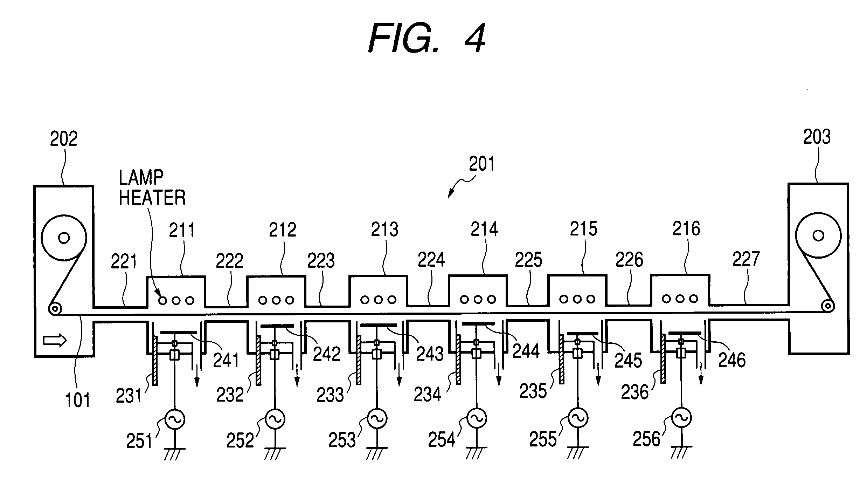

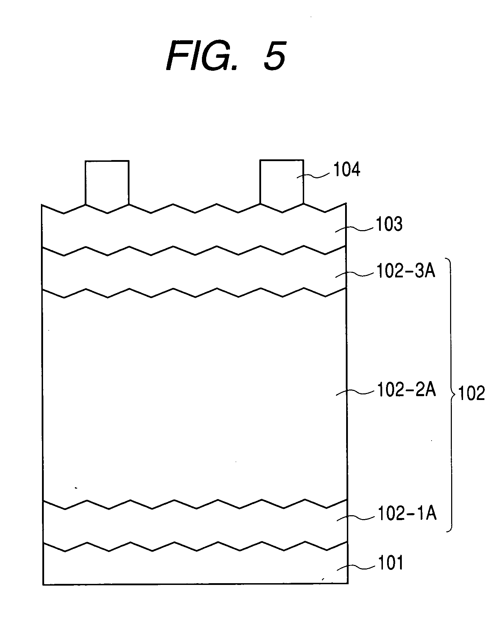

Next, using a deposited-film-forming apparatus 201 shown in Fig. 4, a photovoltaic device shown in Fig. 5 was formed by the following procedure. Fig. 5 is a diagrammatic sectional view showing an example of the photovoltaic device of the present invention, having a silicon type semiconductor layer. In Fig. 5, the same members as those shown in Fig. 1 are denoted by the same reference numerals to avoid repeating description. A semiconductor layer 102 of this photovoltaic device consists of an amorphous n-type semiconductor layer 102-1A, an i-type semiconductor layer 102-2A containing crystal phases, and a p-type semiconductor layer 102-3A containing crystal phases.

Fig. 4 is a diagrammatic sectional view showing an example of a deposited-film formation system used to form the photovoltaic device. The deposited-film-forming apparatus 201 shown in Fig. 4 is constituted of a wind-off container 202, semiconductor-forming vacuum reactors 211 to 216 and a wind-up container 203, which are joined via gas gates 221 to 227. In this deposited-film-forming apparatus 201, a substrate member 101 consisting of a beltlike conductive substrate and at least the zinc oxide film of the present invention is so set as to extend through each vacuum reactor and each gas gate. The beltlike, substrate member 101 is wound off from a bobbin provided in the wind-off container 202, and is wound up on another bobbin in the wind-up container 203.

The semiconductor-forming vacuum reactors 211 to 216 each have a deposition chamber. High-frequency power is applied from high-frequency power sources 251 to 256 to discharge electrodes 241 to 246 in the respective deposition chambers, to cause glow discharge to take place, whereupon source gases are decomprised and the semiconductor layer 102 is deposited on the substrate member 101. Gas feed pipes 231 to 236 for feeding source gases and dilute gases are also connected to the vacuum reactors 211 to 216, respectively.

The semiconductor-forming vacuum reactors 211 to 216 of the deposited-film-forming apparatus 201 shown in Fig. 4 are each provided with a film formation region regulation plate (not shown) for regulating the area of contact of the substrate with each discharge space so that the layer thickness of deposited films formed in the vacuum reactors 211 to 216 can be regulated.

Next, a bobbin wound up with the substrate member 101 was set in the wind-off container 202, and the substrate member 101 was passed through the bring-in side gas gate, vacuum reactors 211 to 216 and the bring-out side gas gate up to the wind-up container 203. Its tension was regulated so that the belt-like substrate member 101 was not slack. Then, the insides of the wind-off container 202, semiconductor-forming vacuum reactors 211 to 216 and wind-up container 203 were sufficiently evacuated.

Next, making the evacuation system operate, source gases and dilute gases were fed into the semiconductor-forming vacuum reactor 212 to 216 through the gas feed pipes 231 ti 236.

Then, 500 cm³/min (normal) of H₂ gas was also fed as gate gases into the respective gas gates through their gate gas feed pipes (not shown). In this state, the evacuation capacity of the evacuation system was regulated to adjust the internal pressure of the semiconductor-forming vacuum reactors 212 to 215 to the stated pressure. Film-forming conditions were as shown in Table 2.

**Table 2**

| Film-forming conditions | |
|---|---|
| Vacuum reactor 211 | |
| Source gases: | SiH₄: 20 cm³/min (normal) |
| | H₂: 100 cm³/min (normal) |
| | PH₃ (diluted to 2% with H₂) : 30 cm³/min (normal) |
| Substrate temperature: | 300°C |
| Internal pressure: | 100 Pa |
| High-frequency power: | 13.56 MHz, 5 mW/cm³ |

| Vacuum reactors 212 to 215 | |
|---|---|
| Source gases: | SiH₄: 30 cm³/min (normal) |
| | SiF₄: 150 cm³/min (normal) |
| | H₂: 1,000 cm³/min (normal) |
| Substrate temperature: | 300°C |
| Internal pressure: | 100 Pa |
| High-frequency power: | 60 MHz, 300 mW/cm³ |

| Vacuum reactor 216 | |
|---|---|
| Source gases: | SiH₄: 10 cm³/min (normal) |
| | H₂: 800 cm³/min (normal) |
| | BF₃ (diluted to 2% with H₂) : 100 cm³/min (normal) |
| Substrate temperature: | 200°C |
| Internal pressure: | 150 Pa |
| High-frequency power: | 13.56 MHz, 30 mW/cm³ |

At the time the internal pressure of the semiconductor-forming vacuum reactor 212 to 216 became stable, the substrate member 101 was started to move from the wind-off container 202 toward the wind-up container 203.

Next, high-frequency power was applied from the high-frequency power sources 251 to 256 to the discharge electrodes 241 to 246 in the vacuum reactors 211 to 216 to cause glow discharge to take place in the deposition chambers in the vacuum reactors 211 to 216. Thus, the amorphous n-type semiconductor layer 102-1A (layer thickness: 50 nm), the i-type semiconductor layer 102-2A containing crystal phases (layer thickness: 3.5 µm) and the p-type semiconductor layer 102-3A containing crystal phases (layer thickness: 10 nm) were formed on the substrate member 101 to form a photovoltaic device. Using a continuous module fabrication apparatus (not shown), the beltlike photovoltaic device thus formed was worked into solar-cell modules of 36 cm × 22 cm each (Example 1-1B).

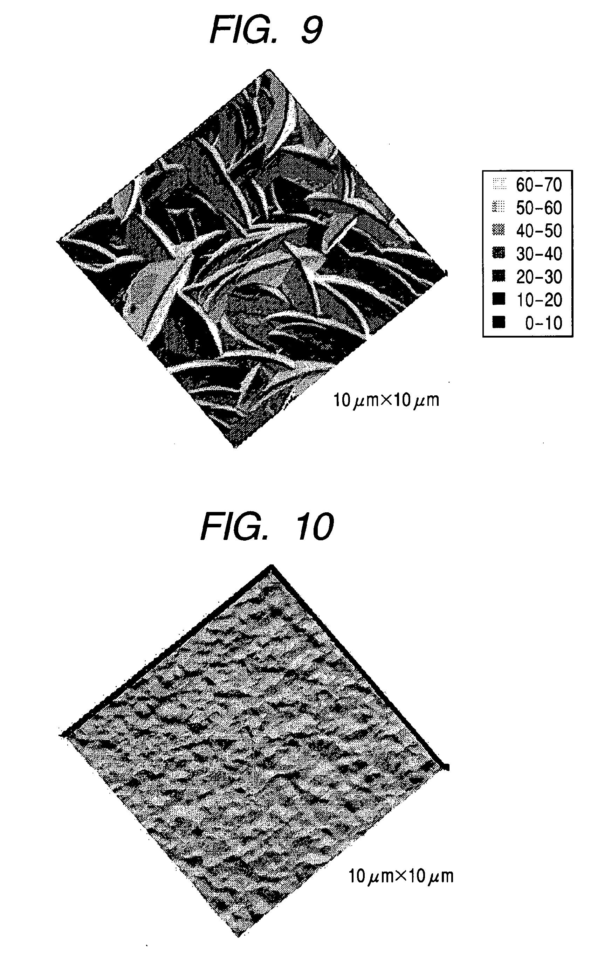

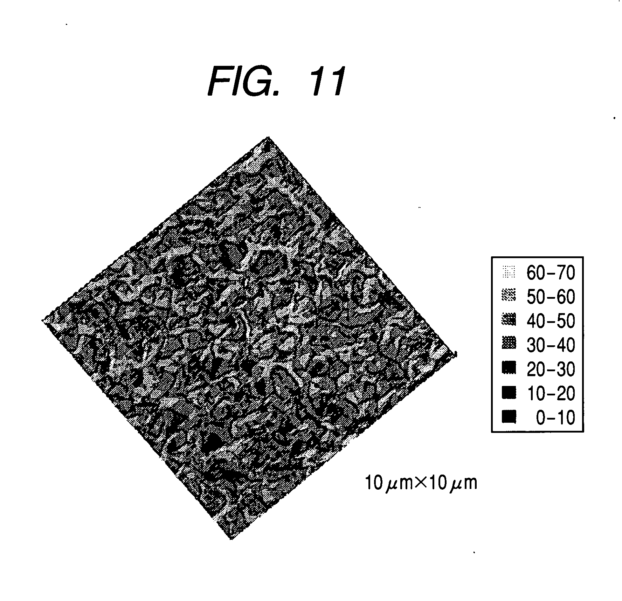

Next, a substrate member and solar-cell modules were produced in the same manner as in Example 1-1 except that the zinc oxide film was formed only by sputtering (Comparative Example 1-1A, Comparative Example 1-1B). Here, the layer thickness of the zinc oxide film 101-3 formed in Comparative Example 1-1B was 3 µm, the total layer thickness of the first and second zinc oxide films 101-3A and 101-3B in Example 1-1A. The surface state of the substrate member 101 produced in Comparative Example 1-1A was also examined in the same manner as in Example 1-1A. The results of measurement are shown in Figs. 10 and 11.

Next, the photoelectric conversion efficiency of the solar-cell modules thus produced in Example 1-1B and Comparative Example 1-1B each was measured with a solar simulator (AM 1.5, 100 mW/cm²). As the result, the solar-cell modules of Example 1-1B were found to have a photoelectric conversion efficiency of 1.10 times the photoelectric conversion efficiency of the solar-cell modules of Comparative Example 1-1B. In particular, it was found that the solar-cell modules of Example 1-1B had short-circuit current density superior to that of the solar-cell modules of Comparative Example 1-1B, and the incident light was more efficiently absorbed.

The surfaces of the substrate members 101 of Example 1-1A and Comparative Example 1-1A were examined in detail to find the following: The surface of the substrate member 101 of Example 1-1A had the plurality of texture constituents comprised of hills, and the texture constituents having hills each had a size of about several micrometers (µm). The hills were constituted of first surfaces formed of curved surfaces and second surfaces formed of substantially plane surfaces, and hills in which the first surfaces have an average angle of inclination to the substrate 101-1 in a size within the range of from 30 degrees or more to 60 degrees or less and the second surfaces have an average angle of inclination in a size within the range of from 10 degrees or more to 35 degrees or less accounted for at least a half of the plurality of hills. Here, the hills were taken out and their lattice fringe were observed on a transmission microscope to find that second surfaces formed of substantially plane surfaces each stood oriented predominantly to the (002)-plane. On the other hand, the surface of the substrate member 101 of Comparative Example 1-1A had smaller texture constituents comprised of hills than those of Example 1-1A, also had the distribution of angles of inclination in a small range, and, as to the shape of hills as well, the hills were not constituted of the first surfaces formed of curved surfaces and the second surfaces formed of substantially plane surfaces.

It is seen from the foregoing that the solar-cell modules having the substrate member 101 and photovoltaic device of the present invention have superior characteristics.

### (Example 1-2)

Substrate members 101, photovoltaic devices and solar-cell modules were produced in the same manner as in Example 1-1 except that the aqueous solution used in forming the second zinc oxide film 101-3B was prepared by formulation where the dextrin concentration and the phthalic-acid concentration were appropriately selected from the range of from 0.01 to 2.0 g/l and the range of from of 5 to 500 µmol/l, respectively.

These substrate members 101, photovoltaic devices and solar-cell modules thus produced were tested in the following way. The photoelectric conversion efficiency of the solar-cell modules produced was measured with a solar simulator (AM 1.5, 100 mW/cm²). The adherence of the photovoltaic device produced was examined by a cross cut tape test (distance between cuts: 1 mm; number of squares: 100).

Further, for the purpose of conducting an accelerated test concerning the environmental resistance under conditions of actual use, the solar-cell modules were installed in a dark place of 85°C in temperature and 85% in relative humidity and kept there for 30 minute, which were thereafter cooled to a temperature of -20°C over a period of 70 minutes and kept there for 30 minutes, which were then again returned to the temperature of 85°C and relative humidity of 85% over a period of 70 minutes. This cycle was repeated 100 times, and thereafter their photoelectric conversion efficiency was measured to examine changes in photoelectric conversion efficiency which were caused by the temperature and humidity test.

The solar-cell modules produced were also deformed in a tubular form in their lengthwise direction and then returned to the original form. This motion was repeated 100 times, and thereafter their photoelectric conversion efficiency was measured to examine changes in characteristics which were caused by the motion of deformation.

The above tests were also likewise conducted in respect of samples of Example 1-1. Those in which, in respect of the photoelectric conversion efficiency, it was at least 0.95 time that of Example 1-1, those which did not cause any peeling of lattices in respect of the cross cut tape test, those in which the photoelectric conversion efficiency after test was at least 0.95 time the conversion efficiency before test in respect of the temperature and humidity and those in which the photoelectric conversion efficiency after test was at least 0.95 time the conversion efficiency before test in respect of the deformation test were judged to be acceptable. Those which were acceptable on all items were regarded as accepted products having superior initial characteristics and environmental resistance. As the result, those in which the aqueous solution used in forming the second zinc oxide film was prepared by formulation where the dextrin concentration and the phthalic-acid concentration were within the range of from 0.05 to 0.3 g/l and within the range of from 15 to 100 µmol/l, respectively, were found to be the accepted products.

To check up with the results of the surface observation of the substrate member 101, the distribution of these accepted products was in agreement with the distribution of those in which the plurality of texture constituents comprised of hills are constituted of first surfaces formed of curved surfaces and second surfaces formed of substantially plane surfaces and texture constituents in which the first surfaces have an average angle of inclination to the substrate 101-1 in a size within the range of from 30 degrees or more to 60 degrees or less and the second surfaces have an average angle of inclination in a size within the range of from 10 degrees or more to 35 degrees or less account for at least a half of the plurality of texture constituents. Many of those having zinc oxide films having regions where the concentration of phthalic acid was in small values showed relatively small angles of inclination and were inferior in initial photoelectric conversion efficiency. Those having zinc oxide films having regions where the concentration of phthalic acid was in large values had zinc oxide films whose texture constituents comprised of hills were small, where regions having undergone abnormal growth were also seen, showing unsatisfactory initial-efficiency and durability test results. Also, in regions where the concentration of dextrin was in small values, there were many sharp-shaped texture constituents, where those having angles of inclination beyond 60 degrees were predominant in some samples, showing unsatisfactory initial-efficiency and durability test results. In regions where the concentration of dextrin was in large values, the angles of inclination were small, showing unsatisfactory initial-efficiency and durability test results.

### (Example 1-3)

Substrate members 101, photovoltaic devices and solar-cell modules were produced by the same procedure as in Example 1-2 except that stainless steel (SUS430-2D) was used as the substrate 101-1. The products obtained were tested in the same manner as in Example 1-2.

As the result, those in which the aqueous solution used in forming the second zinc oxide film was prepared by formulation where the dextrin concentration and the phthalic-acid concentration were within the range of from 0.03 to 0.2 g/l and within the range of from 10 to 80 µmol/l, respectively, were found to be the accepted products. Because of a difference in surface profile of the stainless-steel substrate 101-1 itself, the ranges of the concentrations of dextrin and phthalic acid of the samples found to be the accepted products differed from those in Example 1-2. However, the results were identical in that the distribution of the accepted products in the above tests was in agreement with the distribution of those in which texture constituents in which the first surfaces have an average angle of inclination to the substrate in a size within the range of from 30 degrees or more to 60 degrees or less and the second surfaces have an average angle of inclination in a size within the range of from 10 degrees or more to 35 degrees or less account for at least a half of the plurality of texture constituents.

### (Example 1-4)

Substrate members 101, photovoltaic devices and solar-cell modules were produced by the same procedure as in Example 1-2 except that the reflecting layer 101-2 and the first zinc oxide film 101-3A were formed at temperatures of 50°C and 150°C, respectively, to make the first zinc oxide film 101-3A have surface profile in which the hill-and-dale textured profile was less developed than those in Example 1-2. The products obtained were tested in the same manner as in Example 1-2.

As the result, those in which the aqueous solution used in forming the second zinc oxide film was prepared by formulation where the dextrin concentration and the phthalic-acid concentration were within the range of from 0.05 to 0.4 g/l and within the range of from 30 to 200 µmol/l, respectively, were found to be the accepted products. Because of a difference in surface profile of the first zinc oxide film 101-3A, the ranges of the concentrations of dextrin and phthalic acid of the samples found to be the accepted products differed from those in Example 1-2. However, the results were identical in that the distribution of the accepted products in the above tests was in agreement with the distribution of those in which texture constituents in which the first surfaces have an average angle of inclination to the substrate in a size within the range of from 30 degrees or more to 60 degrees or less and the second surfaces have an average angle of inclination in a size within the range of from 10 degrees or more to 35 degrees or less account for at least a half of the plurality of texture constituents.

### (Example 1-5)

Substrate members 101, photovoltaic devices and solar-cell modules were produced by the same procedure as in Example 1-1 except that first zinc oxide films 101-3A were formed in layer thickness changed in the range of from 10 nm to 1,000 nm. The products obtained were tested in the same manner as in Example 1-2.

As the result, in substrate members 101 whose first zinc oxide films 101-3A were in layer thickness smaller than 20 nm, 80% or more of the texture constituents comprised of hills had lengths of 800 nm or less on a projection chart when projected on the substrate 101-1, showing a tendency to result in low photoelectric conversion efficiency of the solar-cell modules. Such low photoelectric conversion efficiency was due to a low short-circuit current density. Also, the substrate members 101 were produced making larger the concentration of phthalic acid in the aqueous solution when second zinc oxide films 101-3B were formed, in respect to samples whose first zinc oxide films 101-3A were formed in a layer thickness of 1,000 nm. As the result, in substrate members 101 in which the concentration of phthalic acid was more than 500 µmol/l, 80% or more of the texture constituents comprised of hills had lengths of more than 10 µmm on a projection chart when projected on the substrate 101-1, and solar-cell modules made up on these substrate members 101 showed a tendency to result in low values of open-circuit voltage.

From the foregoing, it was found more preferable that, when the hill-and-dale textured profile of the zinc oxide film is projected on the substrate 101-1, texture constituents (hills) having lengths of from 800 nm or more to 10 µm or less in their shape on a projection chart account for at least 80% of the whole texture constituents.

### (Example 1-6)

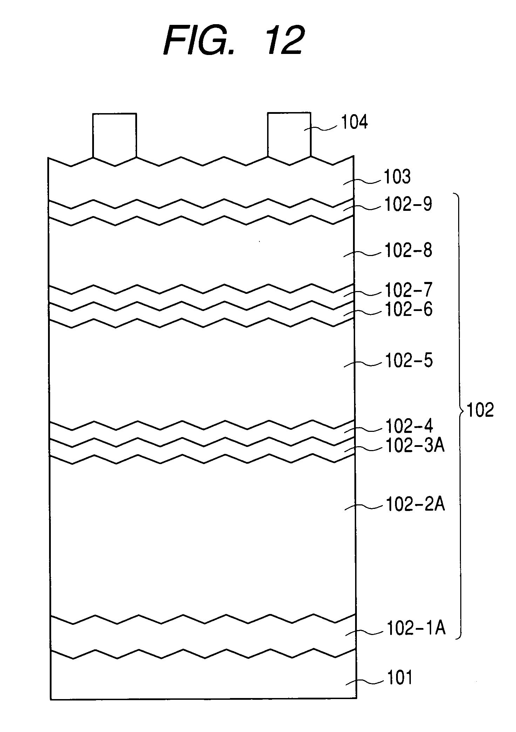

A photovoltaic device shown in Fig. 12 was formed using the same substrate member 101 as that in Example 1-1 and by the same procedure as in Example 1-1. Fig. 12 is a diagrammatic sectional view showing an example of the photovoltaic device of the present invention, having a silicon type semiconductor layer. In Fig. 12, the same members as those shown in Fig. 1 are denoted by the same reference numerals to avoid repeating description.

This photovoltaic device is what is called a triple-type photovoltaic device whose semiconductor layer 102 consists of an amorphous n-type semiconductor layer 102-1A, an i-type semiconductor layer 102-2A containing crystal phases, a p-type semiconductor layer 102-3A containing crystal phases (the above are components of a bottom cell), an amorphous n-type semiconductor layer 102-4, an i-type semiconductor layer 102-5 containing crystal phases, a p-type semiconductor layer 102-6 containing crystal phases, (the above are components of a middle cell), an amorphous n-type semiconductor layer 102-7, an amorphous i-type semiconductor layer 102-8, and a p-type semiconductor layer 102-9 containing crystal phases (the above are components of a top cell).

By the same procedure as in Example 1-1, the bottom cell consisting of the amorphous n-type semiconductor layer (layer thickness: 50 nm), the i-type semiconductor layer containing crystal phases (layer thickness: 3.5 µm) and the p-type semiconductor layer containing crystal phases (layer thickness: 10 nm) was formed on the substrate member 101. This was first taken out of the deposited-film-forming apparatus 201, and then subsequently set in the deposited-film-forming apparatus 201, where the middle cell consisting of the amorphous n-type semiconductor layer (layer thickness: 50 nm), the i-type semiconductor layer containing crystal phases (layer thickness: 2.0 µm) and the p-type semiconductor layer containing crystal phases (layer thickness: 10 nm) was formed on the bottom cell, and further the top cell consisting of the amorphous n-type semiconductor layer (layer thickness: 50 nm), the amorphous i-type semiconductor layer (layer thickness: 0.2 µm) and the p-type semiconductor layer containing crystal phases (layer thickness: 10 nm) was formed on the middle cell. The bottom cell and middle cell were formed under the same conditions as those shown in Table 2 except that only the layer thickness was regulated. The top cell was formed under the conditions shown in Table 3.

Next, solar-cell modules were produced in the same manner as in Example 1-1, and their photoelectric conversion efficiency was measured to find that these were able to absorb more light in the semiconductor layer and achieve higher photoelectric conversion efficiency, than the solar-cell modules of Example 1-1. They also showed good durability test results.

From the foregoing, it is seen that the substrate member 101 and photovoltaic device of the present invention have superior characteristics. In particular, it is seen that they have especially superior characteristics when used in photovoltaic devices having a device construction that enables absorption of more light as in the construction in which a plurality of photovoltaic devices are stacked.

**Table 3**

| Film-forming conditions | |
|---|---|
| Vacuum reactor 211 | |
| Source gas: | SiH₄: 20 cm³/min (normal) |
| | H₂: 100 cm³/min (normal) |
| | PH₃ (diluted to 2% with H₂) |
| | 30 cm³/min (normal) |
| Substrate temperature: | 300°C |
| Internal pressure: | 100 Pa |
| High-frequency power: | 13.56 MHz, 5 mW/cm³ |

| Vacuum reactors 212 to 215 | |
|---|---|
| Source gases: | SiH₄: 50 cm³/min (normal) |
| | H₂: 250 cm³/min (normal) |
| Substrate temperature: | 300°C |
| Internal pressure: | 100 Pa |
| High-frequency power: | 60 MHz, 50 mW/cm³ |

| Vacuum reactor 216 | |
|---|---|
| Source gases: | SiH₄: 10 cm³/min (normal) |
| | H₂: 800 cm³/min (normal) |
| | BF₃ (diluted to 2% with H₂) : |
| | 100 cm³/min (normal) |
| Substrate temperature: | 200°C |
| Internal pressure: | 150 Pa |
| High-frequency power: | 13.56 MHz, 30 mW/cm³ |

### (Example 2-1, Comparative Example 2-1)

In the same manner as in Example 1-1 except that film-forming conditions shown in Table 4 were used, a reflecting layer 101-2 formed of silver (thickness: 800 nm) was deposited on the substrate 101-1 in the vacuum reactor 311, and a first zinc oxide film 101-3A (thickness: 300 nm) was deposited thereon in the vacuum reactors 321 and 313. Further, a second zinc oxide film 101-3B (thickness: 2.7 µm) was formed in the same manner as in Example 1-1 except that, as conditions for forming the second zinc oxide film 101-3B, the aqueous solution was made to have a zinc ion concentration of 0.15 mol/l, a pH of 5.0, an aqueous-solution temperature of 85°C, an anode-to-cathode flowing current value of 15 mA/cm², a dextrin concentration of 0.15 g/l, and a phthalic-acid concentration of 20 µmol/l by adding potassium hydrogen phthalate. Thus, a substrate member 101 was produced (Example 2-1A).

**Table 4**

| Film-forming conditions | |
|---|---|
| Vacuum reactor 311 | |
| Source gas: | Ar: 30 cm³/min (normal) |
| Substrate temperature: | 300°C |
| Internal pressure: | 0.3 Pa |
| Sputtering power: | 2.0 kW |

| Vacuum reactor 312 | |
|---|---|
| Source gas: | Ar: 50 cm³/min (normal) |
| Substrate temperature: | 400°C |
| Internal pressure: | 0.3 Pa |
| Sputtering power: | 4.0 kW |

| Vacuum reactor 313 | |
|---|---|
| Source gas: | Ar: 50 cm³/min (normal) |
| Substrate temperature: | 400°C |
| Internal pressure: | 0.3 Pa |
| Sputtering power: | 4.0 kW |

Subsequently, in the same manner as in Example 1-1 except that film-forming conditions shown in Table 5 were used, an amorphous n-type semiconductor layer 102-1A (layer thickness: 50 nm), an i-type semiconductor layer 102-2A containing crystal phases (layer thickness: 3.5 µm) and a p-type semiconductor layer 102-3A containing crystal phases (layer thickness: 10 nm) were formed on the substrate member 101 to form a photovoltaic device. Using a continuous module fabrication apparatus (not shown), the beltlike photovoltaic device thus formed was worked into solar-cell modules of 36 cm x 22 cm each (Example 2-1B).

Next, a substrate member and solar-cell modules were produced in the same manner as in Example 2-1 except that the zinc oxide film was formed only by sputtering (Comparative Example 2-1A, Comparative Example 2-1B). Here, the layer thickness of the zinc oxide film 101-3 formed in Comparative Example 2-1B was 3 µm, the total layer thickness of the first and second zinc oxide films.

**Table 5**

| Film-forming conditions | |
|---|---|
| Vacuum reactor 211 | |
| Source gases: | SiH₄: 20 cm³/min (normal) |
| | H₂: 80 cm³/min (normal) |
| | PH₃ (diluted to 2% with H₂): |
| | 30 cm³/min (normal) |
| Substrate temperature: | 300°C |
| Internal pressure: | 80 Pa |
| High-frequency power: | 13.56 MHz, 5 mW/cm³ |

| Vacuum reactors 212 to 215 | |
|---|---|
| Source gases: | SiH₄: 50 cm³/min (normal) |
| | SiF₄: 150 cm³/min (normal) |
| | H₂: 1,000 cm³/min (normal) |
| Substrate temperature: | 300°C |
| Internal pressure: | 80 Pa |
| High-frequency power: | 60 MHz, 300 mW/cm³ |

| Vacuum reactor 216 | |
|---|---|
| Source gases: | SiH₄: 10 cm³/min (normal) |
| | H₂: 800 cm³/min (normal) |
| | BF₃ (diluted to 2% with H₂) : |
| | 100 cm³/min (normal) |
| Substrate temperature: | 200°C |
| Internal pressure: | 80 Pa |
| High-frequency power: | 13.56 MHz, 30 mW/cm³ |

Next, the photoelectric conversion efficiency of the solar-cell modules thus produced in Example 2-1B and Comparative Example 2-1B each was measured with a solar simulator (AM 1.5, 100 mW/cm²). As the result, the solar-cell modules of Example 2-1B were found to have a photoelectric conversion efficiency of 1.15 times the photoelectric conversion efficiency of the solar-cell modules of Comparative Example 2-1B. In particular, it was found that the solar-cell modules of Example 2-1B had short-circuit current density superior to that of the solar-cell modules of Comparative Example 2-1B, and the incident light was more efficiently absorbed.

On the respective solar-cell modules, the light collection efficiency for each incident-light wavelength was examined to find that the light collection efficiency of light of 600 nm in wavelength was highest. Then, the surface profiles of the substrate members produced in Example 2-1A and Comparative Example 2-1A were observed using an atomic-force microscope. On each substrate member, the values of A and A/B were first found where the average angle of inclination that was found when the sampling length was set to be 600 nm which was the wavelength at which the light collection efficiency was highest was represented by A and the average angle of inclination that was found when the sampling length was set to be 60 nm, 1/10 of the former, was represented by B. As the result, A was 19.7° and A/B was 0.69 in the substrate member of Example 2-1A, and A was 13.5° and A/B was 0.43 in the substrate member of Comparative Example 2-1A.

From the foregoing, it is seen that the solar-cell modules each having the photovoltaic device of the present invention have superior characteristics.

### (Example 2-2)

A substrate member 101 was produced in the same manner as in Example 2-1 except that, in the aqueous solution in the film-forming container 611, the dextrin concentration was changed to 0.10 g/l, and the phthalic-acid concentration to 30 µmol/l by adding potassium hydrogen phthalate.

The substrate member 101 passed through the pure-water shower 614 and drying unit 615 and then wound up on the wind-up roller 603 was put into a drying container (not shown) connected to a vacuum pump, where the substrate member 101 was dried at an environmental temperature of 250°C for 5 hours in a 10 kPa atmosphere of nitrogen to complete the substrate member 101 (Example 2-2A).

Next, high-frequency power was applied from the high-frequency power sources 251 to 256 to the discharge electrodes 241 to 246 in the semiconductor-forming vacuum reactors 211 to 216 to cause glow discharge to take place in the deposition chambers in the semiconductor-forming vacuum reactors 211 to 216. Thus, an amorphous n-type semiconductor layer (layer thickness: 50 nm), an i-type semiconductor layer containing crystal phases (layer thickness: 3.5 µm) and a p-type semiconductor layer containing crystal phases (layer thickness: 10 nm) were formed on the substrate member 101 to form a photovoltaic device. Using a continuous module fabrication apparatus (not shown), the beltlike photovoltaic device thus formed was worked into solar-cell modules of 36 cm × 22 cm each (Example 2-2B).

Next, a substrate member and solar-cell modules were produced by the same procedure as in Example 1-1 except that the zinc oxide film was formed only by sputtering (Comparative Example 2-2A, Comparative Example 2-2B). Here, the layer thickness of the zinc oxide film formed in Comparative Example 2-2B was 3 µm, the total layer thickness of the first and second zinc oxide films in Example 2-2A.

A zinc oxide film was further formed in the same manner as in Comparative Example 2-2A, and thereafter the substrate member was immersed in a 3% acetic acid solution for 5 minutes. As the result, a surface having a pyramid type hill-and-dale textured profile was formed. Using the substrate member thus obtained, a photovoltaic device and solar-cell modules were produced by the same procedure as in Example 12-1 (Comparative Example 2-2C, Comparative Example 2-2D).

Next, the photoelectric conversion efficiency of the solar-cell modules thus produced in Example 2-2B, Comparative Example 2-2B and Comparative Examples 2-2C and 2-2D each was measured with a solar simulator (AM 1.5, 100 mW/cm²). As the result, the solar-cell modules of Example 2-2B were found to have a photoelectric conversion efficiency of 1.20 times and 1.30 times the photoelectric conversion efficiency of the solar-cell modules of Comparative Example 2-2B and Comparative Example 2-2D, respectively. It was found that the solar-cell modules of Example 2-2B had short-circuit current density superior to that of the solar-cell modules of Comparative Example 2-2B and Comparative Example 2-2D, and the incident light was more efficiently absorbed. Also, in the solar-cell modules of Comparative Example 2-2D, it was also a factor of low photoelectric conversion efficiency that the value of open-circuit voltage was smaller than Example 2-2B.

The surface profiles of the substrate members produced in Example 2-2A, Comparative Example 2-2A and Comparative Example 2-2C were observed using an atomic-force microscope. Inner regions of 10 µm × 10 µm each were covered with lattice points disposed at intervals each corresponding to the sampling length set to be 50 nm. The angles θ of inclination of faces of the rectangular equilateral triangles each one side of which corresponds to the unit lattice length were calculated from the altitude positions of the lattice points. From the relation of fluctuation of the angles θ of inclination thus found, ridge lines of the surface profile were defined. The number of the ridge lines thus defined was regarded as number n of hills with the preset region, and the average diameter r was calculated. The values of length a and breadth b were also calculated by defining the part of dales of the surface profile from the angles θ of inclination. As the result, the average diameter of hills of the substrate member of Example 2-2A was found to be 1,500 nm; the average diameter of hills of the substrate member of Comparative Example 2-2A, 800 nm; and the average diameter of hills of the substrate member of Comparative Example 2-2C, 850 nm. Also, in the substrate member of Example 2-2A, hills the value of a/b of each of which was within the range of from 1.5 or more to 7 or less accounted for 90% of the hills. In the substrate member of Comparative Example 2-2A, however, hills the value of a/b of each of which was within the range of 1.5 or less accounted for the majority of the hills.

In respect of the respective solar-cell modules, the adherence was examined by a cross cut tape test (distance between cuts: 1 mm; number of squares: 100) to find that the film stood peeled at some lattices in the solar-cell modules of Comparative Example 2-2D.

From the foregoing, it is seen that the solar-cell modules each having the photovoltaic device of the present invention have superior characteristics.

### (Example 2-3)

A substrate member and a photovoltaic device were produced in the same manner as in Example 2-1 (Example 2-3A, Example 2-3B).

Next, a substrate member and solar-cell modules were produced by the same procedure as in Example 2-1 except that the zinc oxide film was formed only by sputtering (Comparative Example 2-3A, Comparative Example 2-3B). A substrate member and solar-cell modules were further produced by the same procedure as in Example 2-1 except that the second zinc oxide film 101-3B was formed under conditions providing high angles of inclination (Comparative Example 2-3C, Comparative Example 2-3D). A substrate member and solar-cell modules were still further produced by the same procedure as in Example 2-1 except that the second zinc oxide film 101-3B was formed under conditions providing low angles of inclination (Comparative Example 2-3E, Comparative Example 2-3F). Here, the layer thickness of each of the zinc oxide films formed in these Comparative Examples was 3 µm, the total layer thickness of the first and second zinc oxide films.

Next, on the photovoltaic devices produced in Example 2-3B, Comparative Example 2-3B, Comparative Example 2-3D and Comparative Example 2-3F, transparent conductive layers and collector electrodes were formed. Then, using a continuous module fabrication apparatus (not shown), the beltlike photovoltaic devices thus formed were worked into solar-cell modules of 36 cm × 22 cm each (Example 2-3b, Comparative Example 2-3b, Comparative Example 2-3d, Comparative Example 2-3f). The photoelectric conversion efficiency of the solar-cell modules thus produced was measured with a solar simulator (AM 1.5, 100 mW/cm²).

As the result, the solar-cell modules of Example 2-3b were found to have a photoelectric conversion efficiency of 1.1 times the photoelectric conversion efficiency of the solar-cell modules of Comparative Example 2-3b. The solar-cell modules of Comparative Example 2-3d were also found to have a photoelectric conversion efficiency of 0.85 time the photoelectric conversion efficiency of the solar-cell modules of Example 2-3b because of, though the reason has not been investigated, the triggering of a shunt path. The solar-cell modules of Comparative Example 2-3f were also found to have a photoelectric conversion efficiency of 0.9 time the photoelectric conversion efficiency of the solar-cell modules of Example 2-3b because of an insufficient optical confinement effect. In particular, it was found that the solar-cell modules of Example 2-3b had short-circuit current density superior to that of the solar-cell modules of Comparative Example 2-3b, and the incident light was more efficiently absorbed.

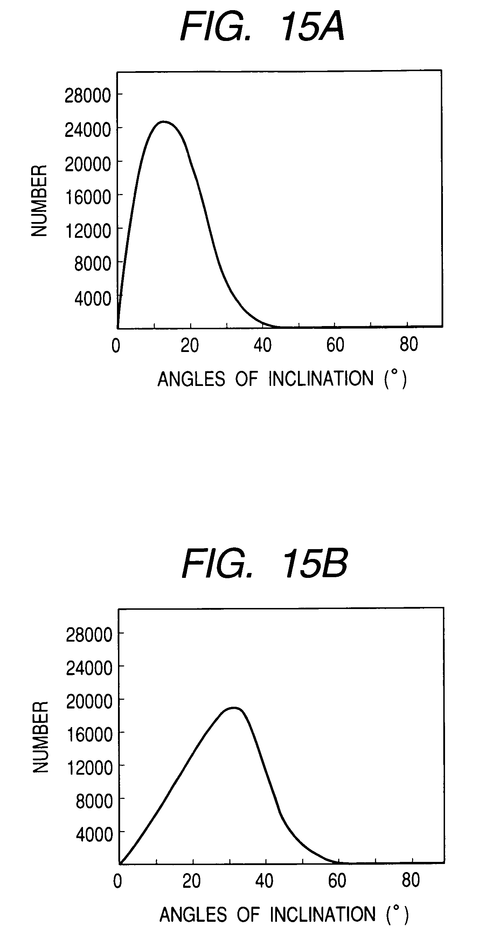

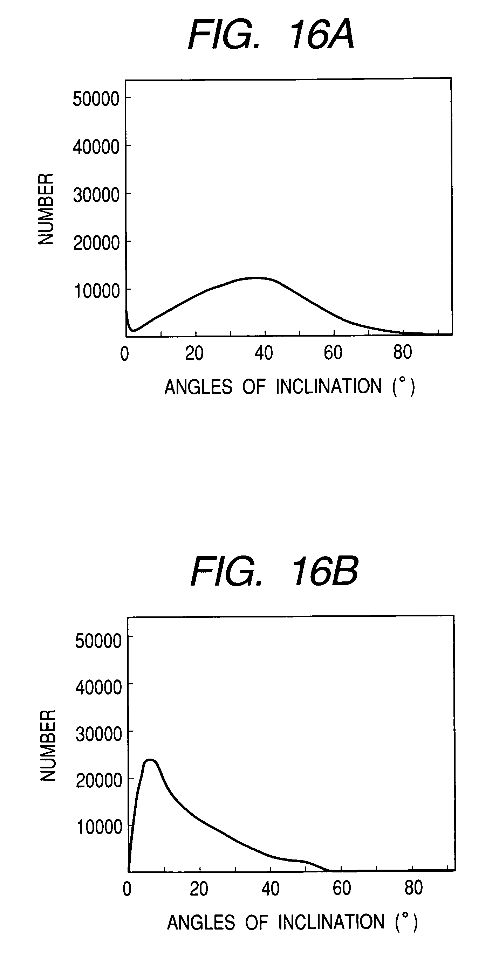

The surface profiles of the zinc oxide films and semiconductor layers of the above Example and Comparative Examples were observed using an atomic-force microscope. In the zinc oxide film (semiconductor layer's underlying layer) of Example 2-3A, its surface hills had angles of inclination that have two maximums in their frequency distribution (Fig. 14B), and, in the semiconductor layer formed thereon, its surface hills had angles of inclination that have one maximum in their frequency distribution (Fig. 14A). In the semiconductor layer's underlying layer of Comparative Example 2-3A, its surface hills had angles of inclination that have one maximum in their frequency distribution (Fig. 15B), and, in the semiconductor layer formed thereon, its surface hills also had angles of inclination that have one maximum in their frequency distribution (Fig. 15A). In the semiconductor layer's underlying layers of Comparative Examples 2-3C and 2-3E as well, their surface hills had angles of inclination that have one maximum in their frequency distribution. As to their frequency distribution, in Comparative Example 2-3C the angles of inclination stood distributed on the side of higher angles (Fig. 16A) than those in Comparative Example 2-3A (Fig. 15B), also having a higher average angle of inclination. Also, in Comparative Example 2-3E, the angles of inclination stood distributed on the side of low angles, also having a low average angle of inclination (Fig. 16B).

From the foregoing, it is seen that the solar-cell modules each having the photovoltaic device of the present invention have superior characteristics.

### (Example 3-1)

Substrate members, photovoltaic devices and solar-cell modules were produced in the same manner as in Example 2-1 except that the aqueous solution used in forming the second zinc oxide film 101-3B was prepared by formulation where the dextrin concentration and the phthalic-acid concentration were appropriately selected from the range of from 0.0 to 2.0 g/l and the range of from of 0.5 to 500 µmol/l, respectively.

These substrate members, photovoltaic devices and solar-cell modules thus produced were tested in the following way. The photoelectric conversion efficiency of the solar-cell modules produced was measured with a solar simulator (AM 1.5, 100 mW/cm²). The adherence of the photovoltaic device produced was examined by a cross cut tape test (distance between cuts: 1 mm; number of squares: 100).

Further, for the purpose of conducting an accelerated test concerning the environmental resistance under conditions of actual use, the solar-cell modules were installed in a dark place of 85°C in temperature and 85% in relative humidity and kept there for 30 minute, which were thereafter cooled to a temperature of -20°C over a period of 70 minutes and kept there for 30 minutes, which were then again returned to the temperature of 85°C and relative humidity of 85% over a period of 70 minutes. This cycle was repeated 100 times, and thereafter their photoelectric conversion efficiency was measured to examine changes in photoelectric conversion efficiency which were caused by the temperature and humidity test.

The solar-cell modules produced were also deformed in a tubular form in their lengthwise direction and then returned to the original form. This motion was repeated 100 times, and thereafter their photoelectric conversion efficiency was measured to examine changes in characteristics which were caused by the motion of deformation.

The above tests were also likewise conducted in respect of samples of Example 2-1. Those in which, in respect of the photoelectric conversion efficiency, it was at least 0.95 time that of Example 2-1, those which did not cause any peeling of lattices in respect of the cross cut tape test, those in which the photoelectric conversion efficiency after test was at least 0.95 time the conversion efficiency before test in respect of the temperature and humidity test and those in which the photoelectric conversion efficiency after test was at least 0.95 time the conversion efficiency before test in respect of the deformation test were judged to be acceptable. Those which were acceptable on all items were regarded as accepted products having superior initial characteristics and environmental resistance. As the result, those in which the aqueous solution used in forming the second zinc oxide film was prepared by formulation where the dextrin concentration and the phthalic-acid concentration were within the range of from 0.0 to 0.5 g/l and within the range of from 10 to 100 µmol/l, respectively, were found to be the accepted products.

To check up with the results of the surface observation of the substrate member, the distribution of these accepted products was in agreement with the distribution of those which satisfy the relations of 40° ≥ A ≥ 15° and 1 ≥ A/B ≥ 0.5 where the average angle of inclination that is found when the sampling length is set to be 600 nm is represented by A and the average angle of inclination that is found when the sampling length is set to be 60 nm is represented by B. Many of those having zinc oxide films having regions where the concentration of phthalic acid was in small values showed relatively small angles of inclination and were inferior in initial photoelectric conversion efficiency. Those having zinc oxide films having regions where the concentration of phthalic acid was in large values had zinc oxide films whose texture constituents comprised of hills were small, where regions having undergone abnormal growth were also seen, showing unsatisfactory initial-efficiency and durability test results. Also, in regions where the concentration of dextrin was in small values, there were many sharp-shaped texture constituents, where those having angles of inclination beyond 60 degrees were predominant in some samples, showing unsatisfactory initial-efficiency and durability test results. In regions where the concentration of dextrin was in large values, the angles of inclination were small, showing unsatisfactory initial-efficiency and durability test results. Also, those which satisfy the relation of 0.9 ≥ A/B ≥ 0.6 were found to be particularly preferred because substrate members were almost free of warpage after photovoltaic devices have been formed. On the other hand, in those which were outside the range of the above relation, curly deformation was seen in which substrate members warped inwards.

### (Example 3-2)

Substrate members, photovoltaic devices and solar-cell modules were produced in the same manner as in Example 2-2 except that the aqueous solution used in forming the second zinc oxide film 101-3B was prepared by formulation where the dextrin concentration and the phthalic-acid concentration were appropriately selected from the range of from 0.01 to 0.8 g/l and the range of from of 1.0 to 100 µmol/l, respectively.

These substrate members, photovoltaic devices and solar-cell modules thus produced were tested in the following way. The photoelectric conversion efficiency of the solar-cell modules produced was measured with a solar simulator (AM 1.5, 100 mW/cm²). The adherence of the photovoltaic device produced was examined by a cross cut tape test (distance between cuts: 1 mm; number of squares: 100).

Further, for the purpose of conducting an accelerated test concerning the environmental resistance under conditions of actual use, the solar-cell modules were installed in a dark place of 85°C in temperature and 85% in relative humidity and kept there for 30 minute, which were thereafter cooled to a temperature of -20°C over a period of 70 minutes and kept there for 30 minutes, which were then again returned to the temperature of 85°C and relative humidity of 85% over a period of 70 minutes. This cycle was repeated 100 times, and thereafter their photoelectric conversion efficiency was measured to examine changes in photoelectric conversion efficiency which were caused by the temperature and humidity test.

The solar-cell modules produced were also deformed in a tubular form in their lengthwise direction and then returned to the original form. This motion was repeated 100 times, and thereafter their photoelectric conversion efficiency was measured to examine changes in characteristics which were caused by the motion of deformation.

The above tests were also likewise conducted in respect of samples of Examples 2-1 to 2-3. Those in which, in respect of the photoelectric conversion efficiency, it was at least 0.95 time that of Example 2-1, those which did not cause any peeling of lattices in respect of the cross cut tape test, those in which the photoelectric conversion efficiency after test was at least 0.95 time the conversion efficiency before test in respect of the temperature and humidity test and those in which the photoelectric conversion efficiency after test was at least 0.95 time the conversion efficiency before test in respect of the deformation test were judged to be acceptable. Those which were acceptable on all items were regarded as accepted products having superior initial characteristics and environmental resistance. As the result, those in which the aqueous solution used in forming the second zinc oxide film was prepared by formulation where the dextrin concentration and the phthalic-acid concentration were within the range of from 0.05 to 0.4 g/l and within the range of from 10 to 60 µmol/l, respectively, were found to be the accepted products.

To check up with the results of the surface observation of the substrate member, the distribution of these accepted products was in agreement with the distribution of those in which the hills which have a size of from 1,000 nm or more to 2,500 nm or less as average diameter and in which the ratio c of the value a of length of each hill to the value b of breadth of each hill, a/b, is within the range of 1.5 ≤ c ≤ 7 account for at least a half of the hills. Those having zinc oxide films having regions where the concentration of zinc ions was in small values had a large average diameter because of relatively poor development of the hills to cause interference in reflection characteristics at a long-wavelength region. Those having zinc oxide films having regions where the concentration of zinc ions was in large values also had a high hill formation density to tend to have a small average diameter, and acicular abnormal growth matter was also seen in some regions. Also, those having zinc oxide films having regions where the concentration of phthalic acid was in large values had zinc oxide films whose hills were small, where regions having undergone abnormal growth were also seen, bringing about relatively poor initial-efficiency and durability test results.

### (Example 4-1)

Substrate members, photovoltaic devices and solar-cell modules were produced by the same procedure as in Example 3-1 except that stainless steel (SUS430-2D) was used as the substrate 101-1. The products obtained were tested in the same manner as in Example 3-1.

As the result, those in which the aqueous solution used in forming the second zinc oxide film was prepared by formulation where the dextrin concentration and the phthalic-acid concentration were within the range of from 0.03 to 0.35 g/l and within the range of from 10 to 80 µmol/l, respectively, were found to be the accepted products. Because of a difference in surface profile of the stainless-steel substrate itself, the ranges of the concentrations of dextrin and phthalic acid of the samples found to be the accepted products differed from those in Example 3-1. However, the results were identical in that the distribution of the accepted products in the above tests was in agreement with the distribution of those which satisfy the relations of 40° ≥ A ≥ 15° and 1 ≥ A/B ≥ 0.5 where the average angle of inclination that is found when the sampling length is set to be 600 nm is represented by A and the average angle of inclination that is found when the sampling length is set to be 60 is represented by B.

### (Example 4-2)

Substrate members, photovoltaic devices and solar-cell modules were produced by the same procedure as in Example 3-1 except that stainless steel (SUS430-2D) was used as the substrate 101-2. The products obtained were tested in the same manner as in Example 3-2.

As the result, those in which the aqueous solution used in forming the second zinc oxide film was prepared by formulation where the dextrin concentration and the phthalic-acid concentration were within the range of from 0.03 to 0.3 g/l and within the range of from 8 to 40 µmol/l, respectively, were found to be the accepted products. Because of a difference in surface profile of the stainless-steel substrate itself, the ranges of the concentrations of zinc ions and phthalic acid of the samples found to be the accepted products differed from those in Example 3-2. However, the results were identical in that the distribution of the accepted products in the above tests was in agreement with the distribution of those in which the hills which have a size of from 1,000 nm or more to 2,500 nm or less as average diameter and in which the ratio c of the value a of length of each hill to the value b of breadth of each hill, a/b, is within the range of 1.5 ≤ c ≤ 7 account for at least a half of the hills.

### (Example 5-1)

Substrate members, photovoltaic devices and solar-cell modules were produced by the same procedure as in Example 3-1 except that the reflecting layer 101-2 and the first zinc oxide film 101-3A were formed at temperatures of 50°C and 150°C, respectively, to make the first zinc oxide film 101-3A have surface profile in which the hill-and-dale textured profile was less developed than those in Example 3-1. The products obtained were tested in the same manner as in Example 3-1.

As the result, those in which the aqueous solution used in forming the second zinc oxide film was prepared by formulation where the dextrin concentration and the phthalic-acid concentration were within the range of from 0.05 to 0.8 g/l and within the range of from 30 to 300 µmol/l, respectively, were found to be the accepted products. Because of a difference in surface profile of the first zinc oxide film 101-3A, the ranges of the concentrations of dextrin and phthalic acid of the samples found to be the accepted products differed from those in Example 3-1. However, the results were identical in that the distribution of the accepted products in the above tests was in agreement with the distribution of those which satisfy the relations of 40° ≥ A ≥ 15° and 1 ≥ A/B ≥ 0.5 where the average angle of inclination that is found when the sampling length is set to be 600 nm is represented by A and the average angle of inclination that is found when the sampling length is set to be 60 is represented by B.

### (Example 5-2)

Substrate members, photovoltaic devices and solar-cell modules were produced by the same procedure as in Example 3-2 except that the reflecting layer 101-2 and the first zinc oxide film 101-3A were formed at temperatures of 50°C and 150°C, respectively, to make the first zinc oxide film 101-3A have surface profile in which the hill-and-dale textured profile was less developed than those in Example 3-2. The products obtained were tested in the same manner as in Example 3-2.

As the result, those in which the aqueous solution used in forming the second zinc oxide film was prepared by formulation where the dextrin concentration and the phthalic-acid concentration were within the range of from 0.10 to 0.8 g/l and within the range of from 30 to 200 µmol/l, respectively, were found to be the accepted products. Because of a difference in surface profile of the first zinc oxide film 101-3A, the ranges of the concentrations of dextrin and phthalic acid of the samples found to be the accepted products differed from those in Example 3-2. However, the results were identical in that the distribution of the accepted products in the above tests was in agreement with the distribution of those in which the hills which have a size of from 1,000 nm or more to 2,500 nm or less as average diameter and in which the ratio c of the value a of length of each hill to the value b of breadth of each hill, a/b, is within the range of 1.5 ≤ c ≤ 7 account for at least a half of the hills.

### (Example 6-1)

The photovoltaic device shown in Fig. 12 was formed using the same substrate member as that in Example 2-1 and by the same procedure as in Example 2-1.

By the same procedure as in Example 2-1, a bottom cell consisting of an amorphous n-type semiconductor layer (layer thickness: 50 nm), an i-type semiconductor layer containing crystal phases (layer thickness: 3.5 µm) and a p-type semiconductor layer containing crystal phases (layer thickness: 10 nm) was formed on the substrate member 101. This was first taken out of the deposited-film-forming apparatus 201, and then subsequently set in the deposited-film-forming apparatus 201, where a middle cell consisting of an amorphous n-type semiconductor layer (layer thickness: 50 nm), an i-type semiconductor layer containing crystal phases (layer thickness: 2.0 µm) and a p-type semiconductor layer containing crystal phases (layer thickness: 10 nm) was formed on the bottom cell, and further a top cell consisting of an amorphous n-type semiconductor layer (layer thickness: 50 nm), an amorphous i-type semiconductor layer (layer thickness: 0.2 µm) and a p-type semiconductor layer containing crystal phases (layer thickness: 10 nm) was formed on the middle cell. The bottom cell and middle cell were formed under the same conditions as those shown in Table 5 except that only the layer thickness was regulated. The top cell was formed under the conditions shown in Table 6.

Next, solar-cell modules were produced in the same manner as in Example 2-1, and their photoelectric conversion efficiency was measured to find that these were able to absorb more light in the semiconductor layer and achieve higher photoelectric conversion efficiency, than the solar-cell modules of Example 2-1. They also showed good durability test results. Also, among the stacked cells of the photovoltaic device formed, the photoelectric conversion efficiency of the bottom cell adjoining to the zinc oxide film was measured under irradiation with bias light and bringing the top cell and middle cell into a short-circuited state, to find that light collection efficiency at a wavelength of 800 nm was highest.

Then, the surface profile of the substrate member produced in this Example was observed using an atomic-force microscope. The value of A and A/B was first found where the average angle of inclination that was found when the sampling length was set to be 800 nm which was the wavelength at which the light collection efficiency in the bottom cell was highest was represented by A and the average angle of inclination that was found when the sampling length was set to be 80 nm, 1/10 of the former, was represented by B. As the result, A was 18.5° and A/B was 0.73.

Next, substrate members, photovoltaic devices and solar-cell modules were produced by the same procedure as in Example 3-1 except that stainless steel (SUS430-2D) was used as the substrate 101-1. The products obtained were tested in the same manner as in Example 3-1. As the result, those in which the aqueous solution used in forming the second zinc oxide film was prepared by formulation where the dextrin concentration and the phthalic-acid concentration were within the range of from 0.04 to 0.40 g/l and within the range of from 15 to 90 µmol/l, respectively, were found to be the accepted products. Because of a difference in surface profile of the stainless-steel substrate itself, the ranges of the concentrations of dextrin and phthalic acid of the samples found to be the accepted products differed from those in Example 3-1. However, the results were identical in that the distribution of the accepted products in the above tests was in agreement with the distribution of those which satisfy the relations of 40° ≥ A ≥ 15° and 1 ≥ A/B ≥ 0.5 where the average angle of inclination that is found when the sampling length is set to be 800 nm is represented by A and the average angle of inclination that is found when the sampling length is set to be 80 is represented by B.

From the foregoing, it is seen that the substrate member and photovoltaic device of the present invention have superior characteristics.

**Table 6**

| Film-forming conditions | |
|---|---|
| Vacuum reactor 211 | |
| Source gases: | SiH₄: 30 cm³/min (normal) |
| | H₂: 150 cm³/min (normal) |
| | PH₃ (diluted to 2% with H₂) : |
| | 30 cm³/min (normal) |
| Substrate temperature: | 250°C |
| Internal pressure: | 100 Pa |
| High-frequency power: | 13.56 MHz, 5 mW/cm³ |

| Vacuum reactors 212 to 215 | |
|---|---|
| Source gases: | SiH₄: 50 cm³/min (normal) |
| | H₂: 200 cm³/min (normal) |
| Substrate temperature: | 250°C |
| Internal pressure: | 100 Pa |
| High-frequency power: | 60 MHz, 50 mW/cm³ |

| Vacuum reactor 216 | |
|---|---|
| Source gases: | SiH₄: 10 cm³/min (normal) |
| | H₂: 800 cm³/min (normal) |
| | BF₃ (diluted to 2% with H₂) : |
| | 100 cm³/min (normal) |
| Substrate temperature: | 250°C |
| Internal pressure: | 150 Pa |
| High-frequency power: | 13.56 MHz, 30 mW/cm³ |

### (Example 6-2)

The photovoltaic device shown in Fig. 12 was formed using the same substrate member as that in Example 2-2 and by the same procedure as in Example 2-1.

Next, solar-cell modules were produced in the same manner as in Example 2-1, and their photoelectric conversion efficiency was measured to find that these were able to absorb more light in the semiconductor layer and achieve higher photoelectric conversion efficiency, than the solar-cell modules of Example 2-2. They also showed good durability test results.

From the foregoing, it is seen that the substrate member and photovoltaic device of the present invention have superior characteristics.

### (Example 6-3)

The photovoltaic device shown in Fig. 12 was formed using the same substrate member as that in Example 2-3A and by the same procedure as in Example 2-1 (Example 6-3A).

Next, a photovoltaic device was formed using the same substrate member as that in Comparative Example 2-3A and by the same procedure as in Example 6-1 (Comparative Example 6-3A).

Next, on the photovoltaic devices produced in Example 6-3A and Comparative Example 6-3A, transparent conductive layers and collector electrodes were formed. Then, using a continuous module fabrication apparatus (not shown), the beltlike photovoltaic devices thus formed were worked into solar-cell modules of 36 cm × 22 cm each (Example 6-3B, Comparative Example 6-3B).

The photoelectric conversion efficiency of these solar-cell modules was measured to find that these were able to absorb more light in the semiconductor layers and achieve higher photoelectric conversion efficiency, than the solar-cell modules of Examples 2-1 to 2-3.

The surface profiles of the semiconductor layers of Example 6-3A and Comparative Example 6-3A, corresponding to the respective solar-cell modules, were observed using an atomic-force microscope. In both Example and Comparative Example, the surface hills of the semiconductor layers had angles of inclination that have one maximum in their frequency distribution. Since the substrate members used are the same as those in Example 6-3A and Comparative Example 6-3A, the surface hills of their zinc oxide films, the semiconductor layer's underlying layers, had angles of inclination that have two maximums and one maximum, respectively, in their frequency distribution.

From the foregoing, it is seen that the solar-cell modules each having the photovoltaic device of the present invention have superior characteristics.

As having been described above, the zinc oxide film formed on a substrate; the zinc oxide film having a plurality of texture constituents comprised of a plurality of hills each having structure wherein a first surface borders on a second surface along one curved line, where texture constituents in which first surfaces the hills of the texture constituents have have an average angle of inclination in a size within the range of from 30 degrees or more to 60 degrees or less and second surfaces have an average angle of inclination in a size within the range of from 10 degrees or more to 35 degrees or less account for at least a half of the plurality of texture constituents, has a surface profile more advantageous for the optical confinement effect and has much higher durability when the substrate member is deformed or cut in a post step after it has been formed, and the photovoltaic device having this zinc oxide film has higher environmental resistance under conditions of actual use, than those of conventionally known hill-and-dale structure.

The photovoltaic device comprising a zinc oxide film and a semiconductor layer having at least one set of a p-i-n junction, wherein, where, in respect of the light absorbed in a p-i-n junction closest to the zinc oxide film, the wavelength of light having the highest light collection efficiency is represented by X, the surface profile of the zinc oxide film on the side close to the semiconductor layer satisfies the relations of A ≥ 15° and 1≥ A/B ≥ 0.5 where the average angle of inclination that is found when the sampling length is set to be X is represented by A and the average angle of inclination that is found when the sampling length is set to be X/10 is represented by B, also shows superior absorption characteristics especially in long wavelength regions, also has superior adherence, has much higher durability when the substrate member is deformed or cut in a post step after it has been formed, can keep the substrate member from straining after the photovoltaic device has been formed, and has higher environmental resistance under conditions of actual use, compared with conventionally known photovoltaic devices.

The photovoltaic device comprising a zinc oxide film and a semiconductor layer which have been superposed in layers; the zinc oxide film having a plurality of hills, where hills which have a size of from 1,000 nm or more to 2,500 nm or less as average diameter found from the number of the hills per preset area and in which the ratio c of the value a of length of each hill to the value b of breadth of each hill, a/b, is within the range of 1.5 ≤ c ≤ 7 account for at least a half of the plurality of hills, can make the zinc oxide film have reflection characteristics more suited for the semiconductor layer, also has superior adherence between the zinc oxide film and a layer adjoining thereto, and has high environmental resistance under conditions of actual use.

The photovoltaic device in which, in its semiconductor layer having a first side and a second side, the first side and the second side each have a plurality of texture constituents, where the texture constituents on the first side have angles of inclination that have two maximums in their frequency distribution and the texture constituents on the second side have angles of inclination that have one maximum in their frequency distribution, also has very superior optical confinement effect and also can be improved in device characteristics without bringing about a difficulty that it triggers a shunt path, compared with conventionally known photovoltaic devices.

In a zinc oxide film having a plurality of texture constituents comprised of hills each having structure wherein a first surface borders on a second surface along one curved line, texture constituents in which first surfaces the hills of the texture constituents have have an average angle of inclination in a size within the range of from 30 degrees or more to 60 degrees or less and second surfaces have an average angle of inclination in a size within the range of from 10 degrees or more to 35 degrees or less account for at least a half of the plurality of texture constituents. This enables improvement in characteristics and durability of zinc oxide films used as optical confinement layers in photovoltaic devices, and also enables formation thereof at a low cost.

## Claims

1. A zinc oxide film formed on a substrate;
the zinc oxide film having a plurality of texture constituents comprised of a plurality of hills each having structure wherein a first surface borders on a second surface along one curved line, where;
texture constituents in which first surfaces the hills of the texture constituents have have an average angle of inclination in a size within the range of from 30 degrees or more to 60 degrees or less and second surfaces have an average angle of inclination in a size within the range of from 10 degrees or more to 35 degrees or less account for at least a half of the plurality of texture constituents.

2. The zinc oxide film according to claim 1, wherein the first surface is formed of a curved surface, and the second surface is formed of substantially a plane surface.

3. The zinc oxide film according to claim 2, wherein the second surface is a (002)-plane of zinc oxide.

4. The zinc oxide film according to claim 2, wherein hills the average angle of inclination of the first surfaces of which is larger than the average angle of inclination of the second surfaces account for at least a half of the plurality of hills.

5. The zinc oxide film according to claim 2, wherein hills whose projected areas of the first surfaces on the substrate are smaller than their projected areas of the second surfaces account for at least a half of the plurality of texture.

6. The zinc oxide film according to claim 2, wherein, when the texture constituents comprised of the hills are projected on the substrate, texture constituents having lengths of from 800 nm or more to 10 µm or less in their shape on a projection chart account for at least 80% of the whole texture constituents.

7. The zinc oxide film according to claim 2, wherein at least part of the zinc oxide film is formed by electrodeposition from an aqueous solution, utilizing electrochemical reaction.

8. The zinc oxide film according to claim 2, wherein the zinc oxide film comprises a multi-layer structure having a first zinc oxide film formed by sputtering and a second zinc oxide film formed on the first zinc oxide film by electrodeposition from an aqueous solution, utilizing electrochemical reaction.

9. A photovoltaic device formed by superposing a semiconductor layer on the zinc oxide film according to claim 2.

10. A photovoltaic device comprising a zinc oxide film and a semiconductor layer having at least one set of a p-i-n junction, wherein;
where, in respect of the light absorbed in a p-i-n junction closest to the zinc oxide film, the wavelength of light having the highest light collection efficiency is represented by X, the surface profile of the zinc oxide film on the light-incident side thereof satisfies the relations of A ≥ 15° and 1 ≥ A/B ≥ 0.5 where the average angle of inclination that is found when the sampling length is set to be X is represented by A and the average angle of inclination that is found when the sampling length is set to be X/10 is represented by B.

11. A photovoltaic device according to claim 10, wherein the value A is A ≤ 40°.

12. A photovoltaic device according to claim 11, wherein the A and B satisfy the relation of 0.9 ≥ A/B ≥ 0.6.

13. A photovoltaic device comprising a zinc oxide film and a semiconductor layer having at least one set of a p-i-n junction, wherein;
the zinc oxide film having a plurality of hills on the light-incident side thereof, and hills which have a size of from 1,000 nm or more to 2,500 nm or less as average diameter found from the number of the hills per preset area and in which the ratio c of the value a of length of each hill to the value b of breadth of each hill, a/b, is within the range of 1.5 ≤ c ≤ 7 account for at least a half of the plurality of hills.

14. A photovoltaic device comprising a zinc oxide film and a semiconductor layer having at least one set of a p-i-n junction, wherein;
the zinc oxide film has a plurality of hills on the light-incident side thereof, and the hills have angles of inclination that have two maximums in their frequency distribution.

15. The photovoltaic device according to claim 14, wherein the semiconductor layer having a p-i-n junction, formed on the zinc oxide film, has a plurality of hills on the light-incident side thereof, and the hills have angles of inclination that have one maximum in their frequency distribution.

16. The photovoltaic device according to claim 14, wherein at least part of the zinc oxide film is formed by electrodeposition from an aqueous solution, utilizing electrochemical reaction.

17. The photovoltaic device according to claim 14, wherein the zinc oxide film comprises a multi-layer structure having a first zinc oxide film formed by sputtering and a second zinc oxide film formed on the first zinc oxide film by electrodeposition from an aqueous solution, utilizing electrochemical reaction.

18. A zinc oxide film formation process which forms a zinc oxide film on a conductive substrate by immersing the conductive substrate and an opposing electrode in an aqueous solution containing at least nitrate ions, zinc ions and a polyhydric carboxylic acid, or an ester thereof, in which carboxyl groups are bonded to a plurality of carbon atoms each having an sp² hybrid orbital, followed by electrification across the conductive substrate and the opposing electrode;
the process comprising the steps of forming a zinc oxide film at a first current density and forming a zinc oxide film at a second current density.

19. The zinc oxide film formation process according to claim 18, wherein the second current density is higher than the first current density.

20. The zinc oxide film formation process according to claim 18, wherein the zinc oxide film formed at the second current density has a thickness larger than the thickness of the zinc oxide film formed at the first current density.

21. The zinc oxide film formation process according to claim 18, wherein zinc ion concentration A and nitrate ion concentration B in the aqueous solution has a relation of 2A ≤ B.
